(19) Europäisches Patentamt / European Patent Office / Office européen des brevets

(11) **EP 4 168 889 B1**

(12) **EUROPÄISCHE PATENTSCHRIFT**

(45) Veröffentlichungstag und Bekanntmachung des Hinweises auf die Patenterteilung:
**05.08.2026 Patentblatt 2026/32**

(21) Anmeldenummer: **21735841.5**

(22) Anmeldetag: **18.06.2021**

(51) Internationale Patentklassifikation (IPC):
**G06F 7/58** [(2006.01)]

(52) Gemeinsame Patentklassifikation (CPC):
**G06F 7/588**

(86) Internationale Anmeldenummer:
**PCT/AT2021/060209**

(87) Internationale Veröffentlichungsnummer:
**WO 2021/253066 (23.12.2021 Gazette 2021/51)**

(54) **ANORDNUNG ZUR ERZEUGUNG EINES ZUFALLSSIGNALS**

ARRANGEMENT FOR GENERATING A RANDOM SIGNAL

AGENCEMENT POUR GÉNÉRER UN SIGNAL ALÉATOIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.06.2020 AT 505212020**

(43) Veröffentlichungstag der Anmeldung:
**26.04.2023 Patentblatt 2023/17**

(73) Patentinhaber: **AIT Austrian Institute of Technology GmbH**
**1210 Wien (AT)**

(72) Erfinder:
• **SCHRENK, Bernhard**
  **2122 Ulrichskirchen (AT)**
• **PACHER, Christoph**
  **1200 Wien (AT)**

(74) Vertreter: **Wildhack & Jellinek Patentanwälte GmbH**
**Landstraßer Hauptstraße 50**
**1030 Wien (AT)**

(56) Entgegenhaltungen:
**WO-A1-2016/099565    WO-A1-2019/006039**
**US-A1- 2015 331 672**

**Beschreibung**

Die Erfindung betrifft eine Anordnung zur Erzeugung eines Zufallssignals gemäß Patentanspruch 1, sowie ein Verfahren zur Erzeugung eines Zufallssignals gemäß Patentanspruch 8.

Die Sicherheit vieler Anwendungen aus der Informations- und Kommunikationstechnologie wie Datenverschlüsselung oder digitalen Signaturen basiert auf einem Zufallssignal bzw. Zufallszahlen als Grundlage. Daher ist ein Zufallssignal höchster Qualität erforderlich, um digitale Sicherheit zu garantieren. Quanten-Zufallszahlengenerierung kann dabei als wichtiges Werkzeug dienen, um ein derartiges Zufallssignal bereitzustellen, da Quantenzustände inhärent unbestimmt sind und daher eine Entropiequelle darstellen. US2015/331672 offenbart ein Beispiel zur Erzeugung von Zufallssignalen.

Aufgabe der Erfindung ist es daher, eine Anordnung und ein Verfahren zur Erzeugung eines Zufallssignals bereitzustellen, mit denen ein nicht vorhersagbares Zufallssignal und somit ein Zufallssignal höchster Qualität erzeugt werden kann.

Die Erfindung löst diese Aufgabe mit einer Anordnung zur Erzeugung eines Zufallssignals umfassend

- eine optische Quelle, insbesondere einen Laser,
- einen polarization-multiplexed in-phase/quadrature Modulator, der folgende Bestandteile umfasst:

    o einen optischen Modulatoreingang, an den die optische Quelle angeschlossen ist,
    o zumindest einen nested Mach-Zehnder-Modulator, wobei der zumindest eine nested Mach-Zehnder-Modulator (1) dem optischen Modulatoreingang nachgeschaltet ist und wobei der zumindest eine nested Mach-Zehnder-Modulator einen optischen Ausgang und zumindest einen elektrischen Eingang zur Vorgabe des Realteils und/oder des Imaginärteils eines optischen Signals aufweist, und

- eine Steuereinheit, die an den elektrischen Eingang des nested Mach-Zehnder-Modulators angeschlossen ist, wobei die Steuereinheit dazu ausgebildet ist, zumindest einen Arbeitspunkt des polarization-multiplexed in-phase/quadrature Modulators vorzugeben.

Erfindungsgemäß ist dabei vorgesehen, dass

- zumindest eine Monitorphotodiode dem polarization-multiplexed in-phase/quadrature Modulator nachgeschaltet ist, wobei die Monitorphotodiode dem optischen Ausgang des nested Mach-Zehnder-Modulators nachgeschaltet ist und einen elektrischen Monitorphotodiodenausgang aufweist, sodass ein vom nested Mach-Zehnder-Modulator bereitgestelltes optisches Signal in ein elektrisches Signal umwandelbar ist, und

dass der Monitorphotodiodenausgang der Monitorphotodiode einen Zufallsausgang der Anordnung zur Bereitstellung eines erzeugten Zufallssignals, insbesondere erzeugter Zufallszahlen, bildet.

Bei einer derartigen Anordnung werden vorteilhafterweise die Quanteneigenschaften von Licht genutzt, um ein Zufallssignal zu erzeugen. Dabei wird ein bekannter optischer I/Q-Modulator genutzt, der häufig in bekannten kohärenten Übertragungssystemen genutzt wird, um das nicht vorhersagbare Zufallssignal zu erstellen, und mit Monitorphotodioden kombiniert.

Somit ist kein separates und hochspezifisches Sub-System für die Generierung von Zufallssignalen höchster Qualität erforderlich, da die in kommerziellen Übertragungssystemen bereits vorhandenen Komponenten zusätzlich für diese Aufgabe verwendet werden können. Es ist lediglich eine geringfügige Änderung in der elektrischen Domäne notwendig, welche im Vergleich zu einer Änderung der Optoelektronik jedoch im Allgemeinen viel einfacher und kosteneffizienter durchzuführen ist.

Weitere vorteilhafte Ausgestaltungen der Erfindung werden in den Merkmalen der abhängigen Ansprüche beschrieben:

Gemäß einer vorteilhaften Ausführungsform der Erfindung kann vorgesehen sein,

- dass der polarization-multiplexed in-phase/-quadrature Modulator einen EingangsStrahlteiler aufweist, wobei der optische Modulatoreingang an den Eingang des Eingangs-Strahlteilers geführt ist, und wobei ein erster Ausgang des Eingangs-Strahlteilers an den optischen Eingang des nested Mach-Zehnder-Modulators geführt ist und
- dass die Anordnung einen weiteren nested Mach-Zehnder-Modulator umfasst, wobei ein zweiter Ausgang des Eingangs-Strahlteilers an den optischen Eingang des weiteren nested Mach-Zehnder-Modulator geführt ist und wobei der weitere nested Mach-Zehnder-Modulator einen optischen Ausgang und zumindest einen elektrischen Eingang zur Vorgabe des Realteils und/oder des Imaginärteils eines optischen Signals aufweist,

dass die Steuereinheit, gegebenenfalls eine weitere Steuereinheit, an den elektrischen Eingang des weiteren nested Mach-Zehnder-Modulators angeschlossen ist,
dass dem polarization-multiplexed in-phase/quadrature Modulator zumindest eine weitere Monitorphotodiode (6) nachgeschaltet ist, wobei die weitere Monitorphotodiode dem optischen Ausgang des weiteren nested Mach-Zehnder-Modulators nachgeschaltet ist und einen elektrischen Monitorphotodiodenausgang aufweist, sodass ein vom weiteren nested Mach-Zehnder-Modulator bereitgestelltes optisches Signal in ein elektrisches Signal umwandelbar ist, und

dass der Monitorphotodiodenausgang der weiteren Monitorphotodiode (6) einen Zufallsausgang der Anordnung zur Bereitstellung eines erzeugten Zufallssignals, insbesondere erzeugter Zufallszahlen, bildet.

Gemäß einer vorteilhaften Ausführungsform der Erfindung, durch die ein ungenaues Teilerverhältnis z.B. am Eingangs-Strahlteiler kompensiert werden kann, kann vorgesehen sein, dass die Steuereinheit, und/oder gegebenenfalls die weitere Steuereinheit, dazu ausgebildet ist, die Arbeitspunkte des nested Mach-Zehnder-Modulators und des weiteren nested Mach-Zehnder-Modulators derart vorzugeben, dass der Gleichanteil des Photodiodenstroms der Monitorphotodiode und der weiteren Monitorphotodiode gleich ist.

Gemäß einer vorteilhaften Ausführungsform der Erfindung kann vorgesehen sein,

- dass die Anordnung einen internen Strahlteiler umfasst, wobei ein erster optischer Ausgang des internen Strahlteilers an den optischen Monitorphotodiodeneingang der Monitorphotodiode angeschlossen ist und/oder
- dass die Anordnung einen weiteren internen Strahlteiler umfasst, wobei ein erster optischer Ausgang des weiteren internen Strahlteilers an den optischen Monitorphotodiodeneingang der weiteren Monitorphotodiode angeschlossen ist.

Gemäß einer vorteilhaften Ausführungsform der Erfindung kann vorgesehen sein, dass der elektrische Monitorphotodiodenausgang der Monitorphotodiode und der elektrische Monitorphotodiodenausgang der weiteren Monitorphotodiode an eine Umwandlungseinheit angeschlossen sind, wobei der Ausgang der Umwandlungseinheit den Zufallsausgang der Anordnung bildet. Auf diese Weise kann ein elektrisches Zufallssignal bereitgestellt werden.

Gemäß einer vorteilhaften Ausführungsform der Erfindung zur Bereitstellung eines verstärkten, analogen Zufallssignals, kann vorgesehen sein, dass die Umwandlungseinheit einen Transimpedanzverstärker umfasst,

wobei der Transimpedanzverstärker einen ersten elektrischen Transimpendanzverstärker-Eingang, einen zweiten elektrischen Transimpendanzverstärker-Eingang und einen elektrischen Transimpedanzverstärker-Ausgang aufweist, wobei der elektrische Monitorphotodiodenausgang der Monitorphotodiode an den ersten elektrischen Transimpendanzverstärker-Eingang angeschlossen ist und wobei der elektrische Monitorphotodiodenausgang der weiteren Monitorphotodiode an den zweiten elektrischen Transimpendanzverstärker-Eingang angeschlossen ist.

Gemäß einer weiteren vorteilhaften Ausführungsform der Erfindung zur Bereitstellung eines verstärkten, analogen Zufallssignals, kann vorgesehen sein, dass der Transimpedanzverstärker dazu ausgebildet ist, eine Funktion der an den elektrischen Monitorphotodiodenausgängen der Monitorphotodioden anliegenden elektrischen Signale, insbesondere der durch die elektrischen Monitorphotodiodenausgängen der Monitorphotodioden fließenden Ströme, zu bilden und zu verstärken, und derart ein verstärktes, analoges Zufallssignal am Transimpedanzverstärker-Ausgang bereitzustellen,

wobei insbesondere vorgesehen ist, dass der Transimpedanzverstärker-Ausgang den Ausgang der Umwandlungseinheit bildet.

Gemäß einer weiteren vorteilhaften Ausführungsform der Erfindung zur Bereitstellung eines verstärkten, analogen Zufallssignals, kann vorgesehen sein, dass der Transimpedanzverstärker dazu ausgebildet ist, die Differenz der an den elektrischen Monitorphotodiodenausgängen der Monitorphotodioden anliegenden elektrischen Signale, insbesondere der durch die elektrischen Monitorphotodiodenausgängen der Monitorphotodioden fließenden Ströme, zu bilden.

Gemäß einer vorteilhaften Ausführungsform der Erfindung zur Bereitstellung eines verstärkten, analogen Zufallssignals mit verbesserter Signalqualität kann vorgesehen sein, die Umwandlungseinheit eine analoge Signalverarbeitungseinheit umfasst, wobei die analoge Signalverarbeitungseinheit einen elektrischen Eingang und einen elektrischen Ausgang aufweist und

wobei der elektrische Transimpedanzverstärker-Ausgang an den elektrischen Eingang der analogen Signalverarbeitungseinheit angeschlossenen ist, wobei die analoge Signalverarbeitungseinheit dazu ausgebildet ist, das am Transimpedanzverstärker-Ausgang bereitgestellte verstärkte, analoge Zufallssignal zu filtern und am elektrischen Ausgang der analogen Signalverarbeitungseinheit bereitzustellen,

wobei insbesondere vorgesehen ist, dass der elektrische Ausgang der analogen Signalverarbeitungseinheit den Ausgang der Umwandlungseinheit bildet.

Gemäß einer vorteilhaften Ausführungsform der Erfindung zur Bereitstellung eines binären Zufallssignals kann vorgesehen sein, dass die Umwandlungseinheit einen Analog-Digital-Wandler umfasst, wobei der Analog-Digital-Wandler einen elektrischen Wandlereingang einen elektrischen Wandlerausgang aufweist und

wobei der elektrische Transimpedanzverstärker-Ausgang an den elektrischen Wandlereingang des Analog-Digital-Wandlers, insbesondere an den der elektrische Ausgang der analogen Signalverarbeitungseinheit, angeschlossenen ist,

wobei der Analog-Digital-Wandler dazu ausgebildet ist, auf Grundlage des am Transimpedanzverstärker-Ausgang, insbesondere am elektrischen Ausgang der analogen Signalverarbeitungseinheit, bereitgestellten verstärkten, analogen Zufallssignal ein binäres Zufallssignal zu erzeugen und am elektrischen Wandlerausgang bereitzustellen,

wobei insbesondere vorgesehen ist, dass der elektrische Wandlerausgang den Ausgang der Umwandlungseinheit bildet.

Gemäß einer vorteilhaften Ausführungsform der Erfindung zur Bereitstellung eines binären Zufallssignals mit verbesserten statistischen Eigenschaften kann vorgesehen sein, dass die Umwandlungseinheit eine digitale Signalverarbeitungseinheit umfasst, wobei die digitale Signalverarbeitungseinheit einen elektrischen Signaleingang und einen elektrischen Signalausgang aufweist und

wobei der elektrische Wandlerausgang an den elektrischen Signaleingang der digitalen Signalverarbeitungseinheit angeschlossen ist, und

wobei die digitale Signalverarbeitungseinheit dazu ausgebildet ist, aus dem am elektrische Wandlerausgang bereitgestellten binären Zufallssignal ein binäres Zufallssignal, insbesondere eine Zufallszahl, mit im Vergleich zur Entropie des vom Analog-Digital-Wandler bereitgestellten binären Zufallssignals verbesserten statistischen Eigenschaften zu erzeugen und an ihrem elektrischen Signalausgang bereitzustellen,

wobei insbesondere vorgesehen ist, dass der elektrische Signalausgang der digitalen Signalverarbeitungseinheit den Ausgang der Umwandlungseinheit bildet.

Verbesserte statistische Eigenschaften sind im Zusammenhang mit der Erfindung so zu verstehen, dass entweder

1) eine Entropie des binären Zufallssignals pro Bit Zufallszahl (= eine Entropie des binären Zufallssignals dividiert durch die Länge des binären Zufallssignals in Bit) vergrößert bzw. erhöht wird, oder
2) der statistische Abstand der Wahrscheinlichkeitsverteilung des binären Zufallssignals zu einer vorgegebenen Wahrscheinlichkeitsverteilung reduziert wird,

im Vergleich zum binären Signal bzw. Zufallssignal, das der digitalen Signalverarbeitungseinheit zugeführt wird.

Dabei ist der statistische Abstand d zweier diskreter Wahrscheinlichkeitsverteilungen X und Y, die über dem gleichen endlichen Alphabet A definiert sind, folgendermaßen definiert:

$$d(X,Y) = \max_{a \in A} |P_X(a) - P_Y(a)|$$

Der statistische Abstand beschreibt den maximalen Unterschied der Wahrscheinlichkeit P ein bestimmtes Ergebnis zu erhalten. Dabei sind zwei Verteilungen X und Y ε-close (ε-nahe), wenn

$$d(X,Y) < \epsilon$$

gilt.

Gemäß einer weiteren vorteilhaften Ausführungsform der Erfindung zur Bereitstellung eines binären Zufallssignals mit verbesserten statistischen Eigenschaften kann vorgesehen sein, dass die Umwandlungseinheit einen Entropieschätzer umfasst, wobei der Entropieschätzer dazu ausgebildet ist, aus dem bekannten Verhalten der optischen Komponenten der Anordnung, insbesondere der optischen Quelle und/oder des polarization-multiplexed in-phase/quadrature Modulators, und der elektrischen Komponenten der Anordnung, insbesondere der Steuereinheit und/oder des Transimpedanzverstärkers und/oder des Analog-Digital-Wandlers, eine Entropie, insbesondere die Shannon-Entropie oder die Min-Entropie, oder eine bedingte Entropie, insbesondere die bedingte Shannon-Entropie oder die bedingte Min-Entropie, des am elektrischen Wandlerausgang bereitgestellten binären Zufallssignals zu berechnen und zur Verfügung zu halten.

Gemäß einer weiteren vorteilhaften Ausführungsform der Erfindung zur Bereitstellung eines binären Zufallssignals mit verbesserten statistischen Eigenschaften kann vorgesehen sein, dass die Umwandlungseinheit einen Entropieschätzer umfasst, wobei der Entropieschätzer dazu ausgebildet ist, aus dem bekannten Verhalten der optischen Komponenten der Anordnung, insbesondere der optischen Quelle und/oder des polarization-multiplexed in-phase/quadrature Modulators, und der elektrischen Komponenten der Anordnung, insbesondere der Steuereinheit und/oder des Transimpedanzverstärkers und/oder des Analog-Digital-Wandlers, sowie anhand vorgegebener Parameter, insbesondere anhand einer vorgegebenen unteren Schranke für eine Entropie, eine parametrisierte Entropie, insbesondere die epsilon-smooth Min-Entropie, oder eine parametrisierte bedingte Entropie, insbesondere die bedingte epsilon-smooth Min-Entropie, des am elektrischen Wandlerausgang bereitgestellten binären Zufallssignals zu berechnen und zur Verfügung zu halten.

Gemäß einer weiteren vorteilhaften Ausführungsform der Erfindung zur Bereitstellung eines binären Zufallssignals mit verbesserten statistischen Eigenschaften kann vorgesehen sein, dass die digitale Signalverarbeitungseinheit dazu ausgebildet ist, die vom Entropieschätzer bestimmte Entropie heranzuziehen, um eine Zufallszahl mit definierter Entropie pro bit, insbesondere mit einer Entropie möglichst nahe an 1 bit pro bit, nach einem Zufallszahlenextraktionsverfahren, insbesondere mittels von Neumann-Extraktion, zu erzeugen und an ihrem elektrischen Signalausgang bereitzustellen.

Unter einer Zufallsvariable mit definierter Entropie pro bit wird im Zusammenhang mit der Erfindung auch eine Zufallsvariable mit definiertem Minimumwert für eine Entropie pro bit bzw. Block oder mit definiertem Minimumwert für den statistischen Abstand zur Gleichverteilung oder mit definiertem Minimumwert für den statistischen Abstand zu einer anderen gewünschten Wahrscheinlichkeitsverteilung verstanden.

Gemäß einer weiteren vorteilhaften Ausführungsform der Erfindung zur Bereitstellung eines binären Zufallssignals mit verbesserten statistischen Eigenschaften kann vorgesehen sein, dass die digitale Signalverarbeitungseinheit dazu ausgebildet ist, die vom Entropieschätzer bestimmte Entropie sowie eine vorgegebene, insbesondere in der digitalen Signalverarbeitungseinheit hinterlegte, Zufallszahl heranzuziehen, um eine Zufallszahl mit definierter Entropie pro bit, insbesondere mit einer Entropie möglichst nahe an 1 bit pro bit oder mit einer Verteilung die epsilon- bzw. $\varepsilon$-nahe an einer Gleichverteilung ist, nach einem Zufallszahlenextraktionsverfahren, insbesondere mittels Universal Hashing und/oder Toeplitz Hashing, zu erzeugen und an ihrem elektrischen Signalausgang bereitzustellen.

Aufgabe der Erfindung ist es weiters, ein Verfahren zur Erzeugung eines Zufallssignals mit einer Anordnung umfassend eine optische Quelle und einen polarization-multiplexed in-phase/quadrature Modulator, insbesondere einer erfindungsgemäßen Anordnung, bereitzustellen,

- wobei ein optisches Signal aus der optischen Quelle, insbesondere einem Laser, dem optischen Eingang des polarization-multiplexed in-phase/quadrature Modulators zugeführt wird,
- wobei zumindest ein Anteil des am optischen Eingang des polarization-multiplexed inphase/quadrature Modulator einlangenden optischen Signal an einen nested Mach-Zehnder-Modulator des polarization-multiplexed in-phase/quadrature Modulator weitergeleitet wird,

Diese Aufgabe wird durch die kennzeichnenden Merkmale des Anspruchs 16 gelöst. Erfindungsgemäß ist dabei vorgesehen,

- dass zumindest ein Anteil des vom nested Mach-Zehnder-Modulator bereitgestellten optischen Ausgangssignals an eine Monitorphotodiode weitergeleitet wird, und
- dass ein Zufallssignal in Form des am elektrischen Monitorphotodiodenausgang der Monitorphotodiode elektrischen Signals bereitgestellt wird.

Gemäß einer vorteilhaften Ausführungsform der Erfindung zur Bereitstellung eines verbesserten elektrischen Zufallssignals kann vorgesehen sein,

- dass ein weiterer Anteil des am optischen Eingang des polarization-multiplexed inphase/quadrature Modulator einlangenden optischen Signal an einen weiteren nested Mach-Zehnder-Modulator des polarization-multiplexed in-phase/quadrature Modulators weitergeleitet wird,
- dass zumindest ein Anteil des vom weiteren nested Mach-Zehnder-Modulator bereitgestellten optischen Ausgangssignals an eine weitere Monitorphotodiode weitergeleitet wird, und
- dass ein Zufallssignal in Form des am elektrischen Monitorphotodiodenausgang der weiteren Monitorphotodiode (6) anliegenden elektrischen Signals bereitgestellt wird.

Gemäß einer vorteilhaften Ausführungsform der Erfindung, durch die ein ungenaues Teilerverhältnis kompensiert werden kann, kann vorgesehen sein, dass die Arbeitspunkte der nested Mach-Zehnder-Modulatoren derart vorgegeben werden, dass der Gleichanteil der Photodiodenströme der beiden Monitorphotodioden gleich ist.

Gemäß einer vorteilhaften Ausführungsform der Erfindung zur Bereitstellung eines verstärkten analogen Zufallssignals kann vorgesehen sein, dass die an den elektrischen Monitorphotodiodenausgängen der Monitorphotodiode anliegenden elektrischen Signale verknüpft werden, sodass derart ein verstärktes, analoges Zufallssignal bereitgestellt wird, wobei insbesondere vorgesehen ist, dass die Differenz der elektrischen Signale gebildet wird.

Gemäß einer vorteilhaften Ausführungsform der Erfindung zur Bereitstellung eines binären Zufallssignals kann vorgesehen sein, dass das verstärkte, analoge Zufallssignal, gegebenenfalls gefiltert und, in ein binäres Zufallssignal umgewandelt wird.

Gemäß einer vorteilhaften Ausführungsform der Erfindung zur Bereitstellung eines verbesserten binären Zufallssignals kann vorgesehen sein, dass die Entropie des binären Zufallssignals ermittelt wird und dass daraus ein binäres Zufallssignal mit verbesserten statistischen Eigenschaften, insbesondere erhöhter Entropie pro bit, vorzugsweise eine Zufallszahl mit erhöhter Entropie, gegebenenfalls unter Einbeziehung einer vorgegebenen Entropiezahl, berechnet wird.

Gemäß einer vorteilhaften Ausführungsform der Erfindung zur Bereitstellung eines weiter verbesserten binären Zufallssignals kann vorgesehen sein, dass das binäre Zufallssignal mit verbesserten statistischen Eigenschaften, insbesondere erhöhter Entropie pro bit, gegebenenfalls unter Einbeziehung einer vorgegebenen Zufallszahl, nach einem Zufallszahlenextraktionsverfahren, insbesondere mittels von Neumann-Extraktion oder Universal Hashing oder Toeplitz Hashing, berechnet wird.

Gemäß einer vorteilhaften Ausführungsform der Erfindung zur abwechselnden Bereitstellung eines Zufallssignals und Übermittlung von Daten kann vorgesehen sein, dass der polarization-multiplexed in-phase/-quadrature Modulator zwei Betriebszustände aufweist,

- wobei im ersten Betriebszustand ein Datensignal über den optischen Ausgang des polarization-multiplexed in-phase/quadrature Modulators übertragen wird und
- wobei im zweiten Betriebszustand zumindest ein Zufallssignal, insbesondere Zufallszahlen, nach einem erfindungsgemäßen Verfahren erzeugt werden und

dass zwischen zwei Betriebszuständen gewechselt wird indem der Arbeitspunkt des polarization-multiplexed in-phase/quadrature Modulators geändert wird.

Gemäß einer vorteilhaften Ausführungsform der Erfindung zur gleichzeitigen Bereitstellung eines Zufallssignals und Übermittlung von Daten kann vorgesehen sein, dass die beiden Betriebszustände gleichzeitig genutzt werden, wobei der Frequenzbereich des polarization-multiplexed in-phase/quadrature Modulators derart aufgeteilt wird, sodass der Frequenzbereich des Datensignals und der Frequenzbereich des zumindest einen Zufallssignals, insbesondere der Zufallszahlen, einander nicht überlappen, sodass ein Übersprechen zwischen den beiden Signalen unterdrückt wird.

Weitere Vorteile und Ausführungsformen der Erfindung ergeben sich aus der Beschreibung und den beiliegenden Zeichnungen.

Besonders vorteilhafte, aber nicht einschränkend zu verstehende Ausführungsbeispiele der Erfindung werden im Folgenden anhand der beiliegenden Zeichnungen schematisch dargestellt und unter Bezugnahme auf die Zeichnungen beispielhaft beschrieben.

Im Folgenden zeigen schematisch:

Fig. 1   ein erstes Ausführungsbeispiel einer erfindungsgemäßen Anordnung,

Fig. 2   ein Ausführungsbeispiel eines nested Mach-Zehnder-Modulators,

Fig. 3   ein zweites Ausführungsbeispiel einer erfindungsgemäßen Anordnung,

Fig. 4   eine Detailansicht der Umwandlungseinheit der Anordnung aus Fig. 3.

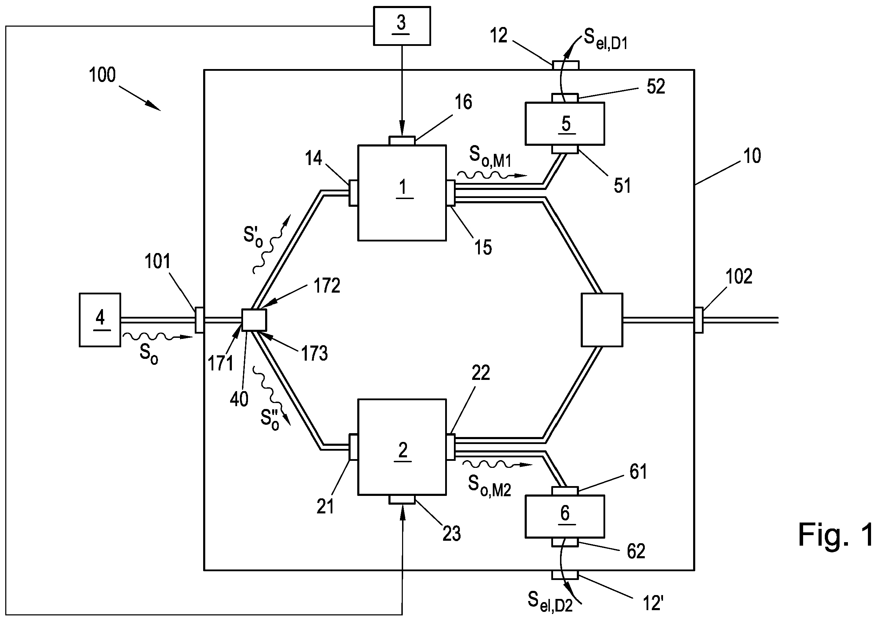

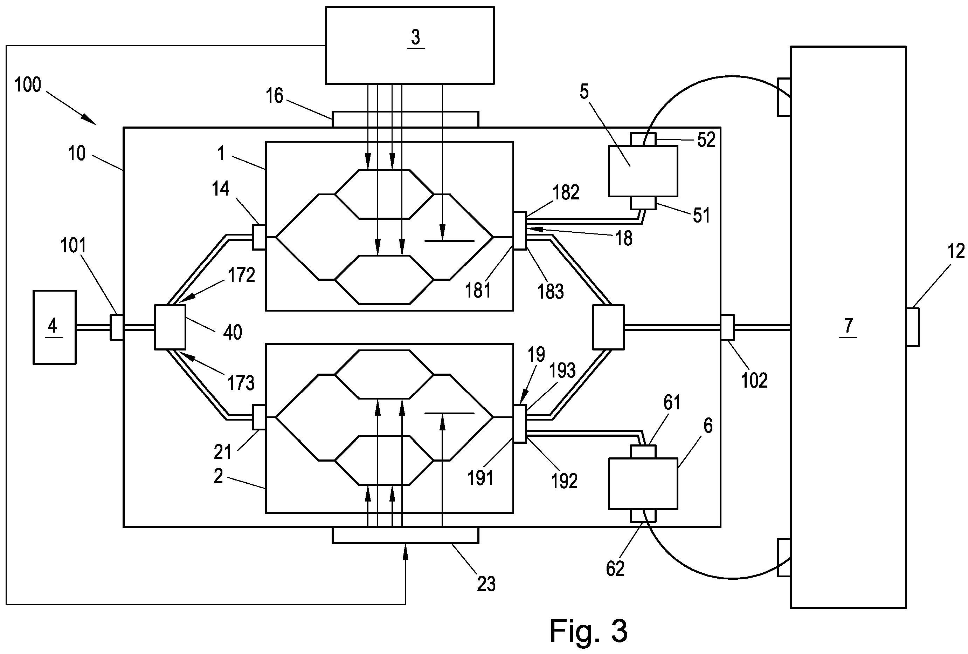

Fig. 1 und Fig. 3 zeigen zwei Ausführungsbeispiele einer erfindungsgemäßen Anordnung 100. Ein drittes, besonders einfach aufgebautes, Ausführungsbeispiel einer erfindungsgemäßen Anordnung 100 wird weiter unten ohne eigene Figur beschrieben. In allen Ausführungsbeispielen einer erfindungsgemäßen Anordnung 100 wird ein polarization-multiplexed in-phase/-quadrature Modulator 10 zur Erzeugung eines Zufallssignals eingesetzt. Die Bezeichnung "polarization-multiplexed" bezieht sich dabei auf die Betriebsart des in-phase/quadrature Modulators. Dies bedeutet, dass die durch den in-phase/quadrature Modulator 10 für die Übertragung von Daten vorgesehene Quadraturamplitudenmodulation in beiden Polarisationsebenen des Lichts durchgeführt wird, d.h. im Polarisationsmultiplex. Da beim Empfänger kohärente Detektion der übermittelten Daten durchgeführt wird, um diese vom optischen in den elektrischen Bereich rückzuführen, ist aufgrund der Polarisationsempfindlichkeit der Detektionsmethode ein geeignetes Management der Lichtpolarisation erforderlich. Diese wird typischerweise durch kohärente Detektion in beiden Polarisationsebenen bewerkstelligt. Somit ergibt sich auch kein Nachteil im Sinn von Komplexität, am Sender beide Polarisationsebenen zu verwenden, während neben der somit erzielten polarisationsunabhängigen Detektion auch die Datenrate verdoppelt werden kann. Die Komponenten eines derartigen polarization-multiplexed in-phase/quadrature Modulators 10 werden im Folgenden näher erläutert.

Der polarization-multiplexed in-phase/quadrature Modulator 10 in Fig. 1 und Fig. 3 bzw. im dritten Ausführungsbeispiel weist einen optischen Modulatoreingang 101 auf, an den eine optische Quelle 4 angeschlossen ist, bei der es sich, wie im Ausführungsbeispiel in Fig. 1 um einen Laser handeln kann.

Ein weiterer Bestandteil des polarization-multiplexed in-phase/quadrature Modulators 10 ist zumindest ein nested Mach-Zehnder-Modulator 1. Ein derartiger nested Mach-Zehnder-Modulator 1 ist beispielsweise in der US 2011/170161 A1 beschrieben und umfasst einen optischen Eingang 14, einen optischen Ausgang 15 und zumindest einen elektrischen Eingang 16.

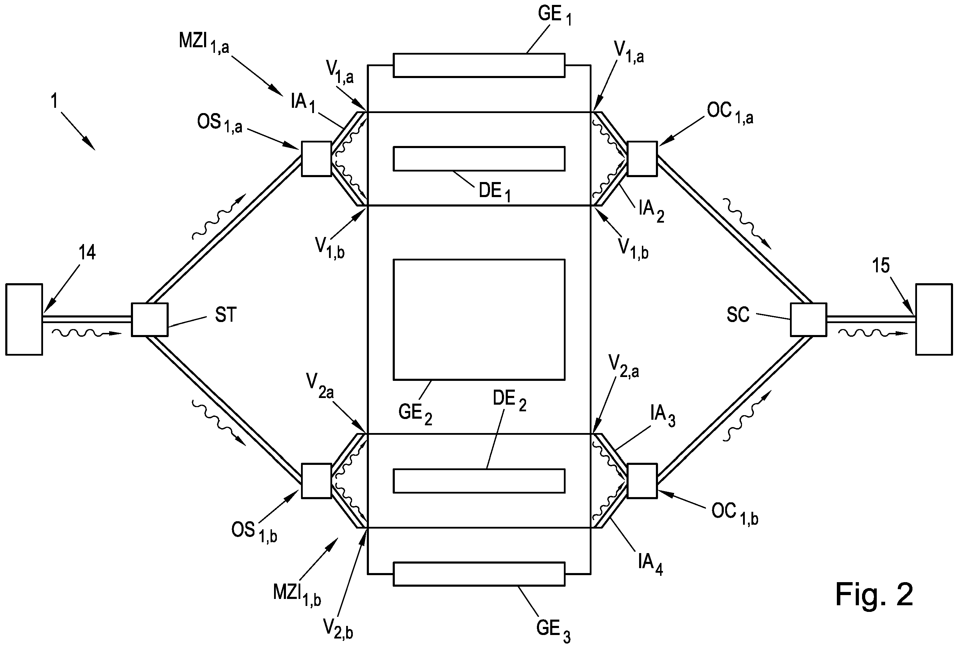

### Ausführungsbeispiel eines nested Mach-Zehnder-Modulators 1, Fig. 2

Jeder derartige nested Mach-Zehnder-Modulator 1 umfasst ein Mach-Zehnder-Interferometer-Paar $MZI_{1,a}$, $MZI_{1,b}$, an seinem optischen Eingang 14 einen optischen Strahlteiler ST, z.B. einen optical intensity splitter, und an seinem optischen Ausgang 15 einen optischen Kombinierer SC, z.B. einen optical intensity combiner.

Vom optischen Eingang 14 gelangen optische Signale über den optischen Strahlteiler ST zum jeweiligen Mach-Zehnder-Interferometer $MZI_{1,a}$, $MZI_{1,b}$. Jedem Mach-Zehnder-Interferometer $MZI_{1,a}$, $MZI_{1,b}$ wird somit ein optisches Signal zugeführt, das auf ein entsprechendes, den optischen Strahlteiler ST am optischen Eingang 14 des nested Mach-Zehnder-Modulators 1, verlassendes, optisches Signal zurückgeht. Jedes Mach-Zehnder-Interferometer $MZI_{1,a}$, $MZI_{1,b}$ erzeugt weiters ein optisches Signal, das durch Kombination der, von den beiden Mach-Zehnder-Interferometern MZI$_{1,a}$, MZI$_{1,b}$ bereitgestellten optischen Signale, im optischen Kombinierer SC am optischen Ausgang 15 des nested Mach-Zehnder-Modulators 1 entsteht.

Der optische Strahlteiler ST am optischen Eingang 14 des nested Mach-Zehnder-Modulators 1 und der optische Kombinierer SC am optischen Ausgang 15 des nested Mach-Zehnder-Modulators 1 können z.B. konventionelle 50/50-Strahlteiler (optical intensity coupler) oder asymmetrische und/oder verstimmbare optische Kombinierer sein.

Jeder nested Mach-Zehnder-Modulator 1 weist insgesamt drei Masseelektroden GE$_1$, ..., GE$_3$ und zwei Steuerelektroden DE$_1$, DE$_2$ auf.

Jedes Mach-Zehnder-Interferometer MZI$_{1,a}$, MZI$_{1,b}$ eines nested Mach-Zehnder-Modulators 1 weist jeweils ein Paar interner optischer Arme IA$_1$, IA$_2$; IA$_3$, IA$_4$ auf, denen jeweils eine Masseelektrode GE$_1$; DE$_3$ zugeordnet ist. Jede Steuerelektrode DE$_1$, DE$_2$ ist jeweils einem Mach-Zehnder-Interferometer MZI$_{1,a}$, MZI$_{1,b}$ zugeordnet und zwischen dessen optischen Armen IA$_1$, IA$_2$; IA$_3$, IA$_4$ angeordnet. Zwei der drei Masseelektroden, in Fig. 2 sind dies die Masseelektroden GE$_1$ und GE$_3$, sind jeweils nur einem Mach-Zehnder-Interferometer zugeordnet, während eine der Masseelektroden, in Fig. 2 ist dies die Masseelektrode GE$_2$, von beiden Mach-Zehnder-Interferometern MZI$_{1,a}$, MZI$_{1,b}$ des nested Mach-Zehnder-Modulators 1 geteilt wird.

Weiters weist jedes Mach-Zehnder-Interferometer MZI$_{1,a}$, MZI$_{1,b}$ des nested Mach-Zehnder-Modulators 1 jeweils einen eigenen optischen Strahlteiler OS$_{1,a}$, OS$_{1,b}$, bzw. optischen Splitter, und jeweils einen eigenen optischen Kombinierer OC$_{1,a}$, OC$_{1,b}$ auf, die jeweils mit den optischen Armen IA$_1$, IA$_2$; IA$_3$, IA$_4$ des jeweiligen Mach-Zehnder Interferometers MZI$_{1,a}$, MZI$_{1,b}$ verbunden sind. Jeder optische Arm IA$_1$, IA$_2$; IA$_3$, IA$_4$ jedes der Mach-Zehnder-Interferometer MZI$_{1,a}$, MZI$_{1,b}$ des nested Mach-Zehnder-Modulators 1 besitzt einen optischen phase shifter, der pro optischem Arm IA$_1$, IA$_2$; IA$_3$, IA$_4$ Halbleiterverzweigungen V$_{1,a}$, V$_{1,b}$; V$_{2,a}$, V$_{2,b}$ und ein Elektrodenpaar GE$_1$, DE$_1$; DE$_1$, GE$_2$; GE$_2$, DE$_2$; DE$_2$, GE$_3$ aufweist.

Bei diesem Elektrodenpaar GE$_1$, DE$_1$; DE$_1$, GE$_2$; GE$_2$, DE$_2$; DE$_2$, GE$_3$ handelt es sich um eine Kombination aus Steuerelektrode DE$_1$, DE$_2$ und Masseelektrode GE$_1$, ..., GE$_3$, wie oben beschrieben. Über diese Elektroden werden elektrische Spannungen an den Halbleiterverzweigungen V$_{1,a}$, V$_{1,b}$; V$_{2,a}$, V$_{2,b}$ angelegt, um die optischen phase shifters der internen optischen Arme IA$_1$, IA$_2$; IA$_3$, IA$_4$ jedes Mach-Zehnder-Interferometers MZI$_{1,a}$, MZI$_{1,b}$ zu steuern. Die zentral angeordnete Steuerelektrode DE$_1$, DE$_2$ steuert dabei den optischen phase shifter des jeweiligen Mach-Zehnder-Interferometers MZI$_{1,a}$, MZI$_{1,b}$.

Ein optisches Trägersignal kann an einem der optischen Eingänge eines der Mach-Zehnder-Interferometer MZI$_{1,a}$, MZI$_{1,b}$ des nested Mach-Zehnder-Modulators 1 empfangen werden. Dieses optische Trägersignal kann ein unmodulierter, kontinuierlicher, kohärenter Lichtstrahl sein, der von einem Laser ausgesendet werden kann. Alternativ dazu kann es sich, wie in Fig. 1, um einen kohärenten Lichtstrahl handeln, der von einer anderen optischen Komponente wie einem Strahlteiler bzw. einem optical intensity splitter oder auch von einem anderen optischen Modulator stammen kann.

Die Halbleiterverzweigungen V$_{1,a}$, V$_{1,b}$; V$_{2,a}$, V$_{2,b}$ in den beiden Armen IA$_1$, IA$_2$; IA$_3$, IA$_4$ des jeweiligen Mach-Zehnder-Interferometers MZI$_{1,a}$, MZI$_{1,b}$ werden elektrisch angesteuert, einen einlangenden Strom an Datensymbolen auf das optische Trägersignal aufzumodulieren. Dabei kann ein Gegenstück eines Datensignals an einer zentralen Steuerelektrode DE$_1$, DE$_2$ zugeführt werden, während das Datensignal an der jeweils anderen zentralen Steuerelektrode DE$_1$, DE$_2$ zugeführt wird. Es kann auch an einer zentralen Steuerelektrode DE$_1$, DE$_2$ eine Spannung angelegt werden, während an der jeweils anderen zentralen Steuerelektrode DE$_1$, DE$_2$ eine Spannung mit gegenteiligem Vorzeichen angelegt wird.

Am elektrischen Eingang 16 des nested Mach-Zehnder-Modulators 1 können also elektrische Signale vorgegeben werden, mit denen der Arbeitspunkt des nested Mach-Zehnder-Modulators 1 eingestellt und der Realteils und/oder der Imaginärteil des optischen Signals beeinflusst werden können.

**Erstes Ausführungsbeispiel einer erfindungsgemäßen Anordnung 100, Fig. 1**

Der polarization-multiplexed in-phase/quadrature Modulator 10 im ersten Ausführungsbeispiel in Fig. 1 umfasst einen Eingangs-Strahlteiler 40, der einen Eingang 171, einen ersten Ausgang 172 und einen zweiten Ausgang 173 besitzt. Der optische Modulatoreingang 101 ist an den Eingang 171 des Eingangs-Strahlteilers 40 geführt.

Der erste Ausgang 172 des Eingangs-Strahlteilers 40 des polarization-multiplexed inphase/quadrature Modulator 10 ist im ersten Ausführungsbeispiel gezeigt in Fig. 1 an den optischen Eingang 14 des nested Mach-Zehnder-Modulators 1 geführt.

Über den elektrischen Eingang 16 des nested Mach-Zehnder-Modulators 1 werden im ersten Ausführungsbeispiel einer erfindungsgemäßen Anordnung 100 von einer Steuereinheit 3 die elektrische Signale vorgegeben, mit denen der Arbeitspunkt des nested Mach-Zehnder-Modulators 1 eingestellt wird.

Eine Monitorphotodiode 5 ist dem optischen Ausgang 15 des nested Mach-Zehnder-Modulators 1, nachgeschaltet. Im ersten Ausführungsbeispiel wird die Monitorphotodiode 5 durch einen zum optischen Datenausgang des nested Mach-Zehnder-Modulators 1 komplementären Mach-Zehnder-Interferometer-Ausgang des nested Mach-Zehnder-Modulators 1 angespeist. Dies ist schematisch durch die beiden, aus dem optischen Ausgang 15 des nested Mach-Zehnder-Modulators 1 führenden optischen Pfade in Fig. 1 angedeutet.

Die Monitorphotodiode 5 kann jedoch auch auf andere Weise dem polarization-multiplexed in-phase/-quadrature Modulator 10 bzw. dem optischen Ausgang 15 des nested Mach-Zehnder-Modulators 1, nachgeschaltet sein. Dies kann z.B. über Einfügen eines Strahlteilers erfolgen, d.h. es werden typischerweise z.B. 10% des optischen Ausgangs 15 auf die Monitorphotodiode 5 abgezweigt. Dies wird im Zusammenhang mit dem optisches Signal $S_O$ der optischen Quelle 4 auf Seite 16 bzw. Fig. 3 noch näher erläutert. Auf weitere Möglichkeiten wird im Zusammenhang mit dem zweiten und dritten Ausführungsbeispiel weiter unten näher eingegangen.

Wie zuvor bereits beschrieben, stellt jedes Mach-Zehnder-Interferometer $MZI_{1,a}$, $MZI_{1,b}$ zwei Ausgänge bereit, die komplementär wirken, d.h. ein Ausgang erfährt konstruktive, der andere destruktive Interferenz. Dabei kann es sich z.B. um den Ausgang OC1,a und einen weiteren, in Fig. 2 nicht eingezeichneten Ausgang OC1,a* handeln, der nicht nach rechts unten in Richtung des optischen Kombinierers SC abzweigt, sondern nach rechts oben in Richtung einer Monitorphotodiode. Im Fall, dass die Monitorphotodiode 5 am komplementären Ausgang angeschlossen ist, steht der jeweils andere, optische Ausgang des jeweiligen Mach-Zehnder-Interferometers $MZI_{1,a}$, $MZI_{1,b}$ des nested Mach-Zehnder-Modulators 1 z.B. für Datenübertragung komplementär zum Montiorphotodiodeneingang 51 der Monitorphotodiode 5 zur Verfügung. In diesem Fall wird der Arbeitspunkt des nested Mach-Zehnder-Modulators 1 so eingestellt, dass am optischen Ausgang des jeweiligen Mach-Zehnder-Interferometers $MZI_{1,a}$, $MZI_{1,b}$ minimale Leistung abgegeben wird, sodass am Monitorphotodiodeneingang 51 der Monitorphotodiode 5 maximale Leistung auftritt, da die beiden Ausgänge der Mach-Zehnder-Interferometer $MZI_{1,a}$, $MZI_{1,b}$ komplementär, also gegenläufig ausgebildet sind.

Die Monitorphotodiode 5 weist einen elektrischen Monitorphotodiodenausgang 52 auf, der in der einfachen Ausgestaltung einer erfindungsgemäßen Anordnung 100, wie sie in Fig. 1 dargestellt ist, einen Zufallsausgang 12 der Anordnung 100 bildet. An diesem Zufallsausgang 12 kann ein erzeugtes, analoges Zufallssignal, insbesondere erzeugte Zufallszahlen, bereitgestellt werden.

Die Kombination einer derartigen Monitorphotodiode 5 mit einem polarization-multiplexed in-phase/-quadrature Modulator 10 und einer optischen Quelle 4 ermöglicht es vorteilhafterweise, den zufälligen Charakter des von der optischen Quelle 4 ausgesandten Lichts für die Erzeugung eines Zufallssignals zu verwenden. Auf konkrete Ausführungsbeispiele eines erfindungsgemäßen Verfahrens wird weiter unten näher eingegangen.

Optional ist es auch möglich, dass die Anordnung 100, wie in Fig. 1, einen weiteren nested Mach-Zehnder-Modulator 2 aufweist, der denselben Aufbau wie der nested Mach-Zehnder-Modulator 1, der oben beschrieben wurde, aufweist. Der zweite Ausgang 173 des Eingangs-Strahlteilers 40 kann in diesem Fall, wie im ersten Ausführungsbeispiel in Fig. 1, an den optischen Eingang 21 des weiteren nested Mach-Zehnder-Modulators 2 geführt sein.

Wenn die erfindungsgemäße Anordnung 100 wie in Fig. 1 und Fig. 3 zwei nested Mach-Zehnder-Modulatoren 1, 2 umfasst, ist das Vorhandensein eines Eingangs-Strahlteilers 40 besonders vorteilhaft, da in diesem Fall beide nested Mach-Zehnder-Modulatoren 1, 2 gleichzeitig für die Erzeugung von Zufallssignalen herangezogen werden können.

Der weitere nested Mach-Zehnder-Modulator 2 weist wie der nested Mach-Zehnder-Modulator 1 einen optischen Ausgang 22 und zumindest einen elektrischen Eingang 23 auf, der zur Einstellung des Arbeitspunktes des weiteren nested Mach-Zehnder-Modulators 2 und somit zur Vorgabe des Realteils und/oder des Imaginärteil des optischen Ausgangssignals dient, das den weiteren nested Mach-Zehnder-Modulator 2 verlässt.

Über den elektrischen Eingang 23 des weiteren nested Mach-Zehnder-Modulators 2 werden im ersten Ausführungsbeispiel einer erfindungsgemäßen Anordnung 100 von der Steuereinheit 3 die elektrische Signale vorgegeben, mit denen auch der Arbeitspunkt des nested Mach-Zehnder-Modulators 1 eingestellt wird. Optional ist es auch möglich, dass eine von der Steuereinheit 3 verschiedene, weitere Steuereinheit den weiteren nested Mach-Zehnder-Modulator 2 über den elektrischen Eingang 23 ansteuert.

Im ersten Ausführungsbeispiel ist eine weitere Monitorphotodiode 6 dem polarization-multiplexed in-phase/quadrature Modulator 10 nachgeschaltet, bzw. an den optischen Ausgang 22 des weiteren nested Mach-Zehnder-Modulators 2 angeschlossen. Wie die Monitorphotodiode 5 ist auch die weitere Monitorphotodiode 6 durch einen zum optischen Datenausgang des weiteren nested Mach-Zehnder-Modulators 2 komplementären Mach-Zehnder-Interferometer-Ausgang des weiteren nested Mach-Zehnder-Modulators 2 angespeist. Dies ist schematisch durch die beiden, aus dem optischen Ausgang 22 des weiteren nested Mach-Zehnder-Modulators 2 führenden optischen Pfade in Fig. 1 angedeutet. Der Arbeitspunkt des weiteren nested Mach-Zehnder-Modulators 2 wird dabei auf dieselbe Weise eingestellt, wie dies für die Monitorphotodiode 5 weiter oben beschrieben wurde.

Die weitere Monitorphotodiode 6 weist einen elektrischen Monitorphotodiodenausgang 62 auf. Der elektrische Monitorphotodiodenausgang 62 kann in einer einfachen Ausgestaltung einer erfindungsgemäßen Anordnung 100 einen weiteren Zufallsausgang 12' der Anordnung 100 bilden. Auch an diesem weiteren Zufallsausgang 12' kann ein erzeugtes Zufallssignal, insbesondere erzeugte Zufallszahlen, bereitgestellt werden.

In einem besonders einfachen Ausführungsbeispiel eines erfindungsgemäßen Verfahrens zur Erzeugung eines Zufallssignals mit der Anordnung 100 des ersten Ausführungsbeispiels wird ein unmoduliertes, optisches Signal $S_o$ durch die optische Quelle 4, z.B. einem Laser, in den polarization-multiplexed in-phase/quadrature Modulator 10 eingespeist und an den nested Mach-Zehnder-Modulator 1 weitergeleitet. In der Regel handelt es sich hierbei um ein möglichst starkes optisches Signal $S_o$. Die Leistung der Quelle 4 wird dabei idealerweise in einem Bereich gewählt, der gemäß den optischen Verlusten durch den Eingangs-Strahlteiler 40, des nested Mach-Zehnder Modulators 1 bzw. 2 sowie eines eventuellen optischen Strahlteilers am nested Mach-Zehnder Ausgang die Monitorphotodiode 5 bzw. 6 nicht sättigt. Zudem soll die Leistung, die an der Monitorphotodiode 5 bzw. 6 auftrifft, unter Einbehaltung der vorherigen Bedingung maximiert werden, um einen maximalen Pegelabstand (und somit Unterscheidbarkeit) zum Verstärkerrauschen sicherzustellen. Typische Leistungspegel, um diese beiden Bedingungen zu gewährleisten, liegen im Bereich von 6 bis 16 dBm.

Für die Durchführung eines erfindungsgemäßen Verfahrens ist es dabei ausreichend, wenn zumindest ein Anteil $S'_o$ des am optischen Eingang 101 des polarization-multiplexed in-phase/quadrature Modulators 10 einlangenden optischen Signal $S_o$ an den nested Mach-Zehnder-Modulator 1 weitergeleitet wird, wie dies der Fall sein kann, wenn ein Eingangs-Strahlteiler 40 vorgesehen ist. Durch den nested Mach-Zehnder-Modulator 1 wird der Anteil $S'_o$ des am optischen Eingang 101 einlangenden optischen Signals $S_o$ entsprechend dem vorgegebenen Arbeitspunkt moduliert. Obwohl für die Generierung eines Zufallssignal keine ähnlich wie bei der Datenübertragung eingesetzten schnellen Modulation notwendig ist, kann der Arbeitspunkt günstigerweise so definiert werden, dass die zur Monitorphotodiode 5 zugeführte optische Leistung durch den nested Mach-Zehnder-Modulator 1 definiert werden kann. Mit der Einstellung des Arbeitspunktes kann durch die interferometrische Struktur des Mach-Zehnder-Modulators 1, wie in Abbildung 2 erläutert, die Leistung dessen optischen Ausgangs 15 gesteuert werden. Der Mach-Zehnder-Modulator 1 erscheint dadurch als ein variabler optischer Abschwächer.

Zur Erzeugung eines Zufallssignals wird zumindest ein Anteil $S_{o,M1}$ des vom nested Mach-Zehnder-Modulator 1 bereitgestellten optischen Ausgangssignals an die Monitorphotodiode 5 weitergeleitet und in ein elektrisches Signal $S_{el,D1}$ umgewandelt. Am elektrischen Monitorphotodiodenausgang 52 der Monitorphotodiode 5 liegt somit schließlich ein elektrisches Signal $S_{el,D1}$ an. Dieses elektrische Signal $S_{el,D1}$ der Monitorphotodiode 5 stellt ein Zufallssignal dar, da der inhärent zufällige Charakter des von der optischen Quelle 4 eingespeisten optischen Signals $S_o$, der durch dessen Quanteneigenschaften bedingt ist, genutzt werden kann. Die Anzahl der in einem Zeitintervall detektierten Photonen und dadurch erzeugten Ladungsträgerpaare und damit der durch die Monitorphotodiode fließende Strom können jeweils als Zufallsvariable mit Poissonverteilung beschrieben werden. Diese Zufälligkeit des Stroms bezeichnet man als Schrotrauschen.

Somit bildet der elektrische Monitorphotodiodenausgang 52 der Monitorphotodiode 5 einen Zufallsausgang 12 der Anordnung 100.

Im ersten Ausführungsbeispiel einer erfindungsgemäßen Anordnung 100 in Fig. 1 sind, wie bereits zuvor beschrieben, ein weiterer nested Mach-Zehnder-Modulator 2 und eine weitere Monitorphotodiode 6 vorhanden. In diesem Fall kann ein weiterer Anteil $S''_o$ des am optischen Eingang 101 des polarization-multiplexed in-phase/quadrature Modulators 10 einlangenden optischen Signals $S_o$ an den weiteren nested Mach-Zehnder-Modulator 2 weitergeleitet und von diesem moduliert werden.

Anschließend wird zumindest ein Anteil $S_{o,M2}$ des vom weiteren nested Mach-Zehnder-Modulator 2 bereitgestellten optischen Ausgangssignals an die weitere Monitorphotodiode 6 weitergeleitet und in ein elektrisches Signal $S_{el,D2}$ umgewandelt. Wie oben schrieben, wird in diesem Fall am elektrischen Monitorphotodiodenausgang 62 der weiteren Monitorphotodiode 6 das elektrische Signal $S_{el,D2}$ als Zufallssignal bereitgestellt. Der elektrische Monitorphotodiodenausgang 62 der weiteren Monitorphotodiode 6 bildet somit im ersten Ausführungsbeispiel einen weiteren Zufallsausgang 12' der Anordnung 100.

## Zweites Ausführungsbeispiel einer erfindungsgemäßen Anordnung 100, Fig. 3

Wie in Fig. 3 ersichtlich ist, umfasst das zweite Ausführungsbeispiel einer erfindungsgemäßen Anordnung 100 zusätzlich zu den Komponenten des ersten Ausführungsbeispiels dargestellt in Fig. 1 eine Umwandlungseinheit 7, deren Ausgang den Zufallsausgang 12 der Anordnung 100 bildet. Der elektrische Monitorphotodiodenausgang 52 der Monitorphotodiode 5 und der elektrische Monitorphotodiodenausgang 62 der weiteren Monitorphotodiode 6 sind an die Umwandlungseinheit 7 angeschlossen.

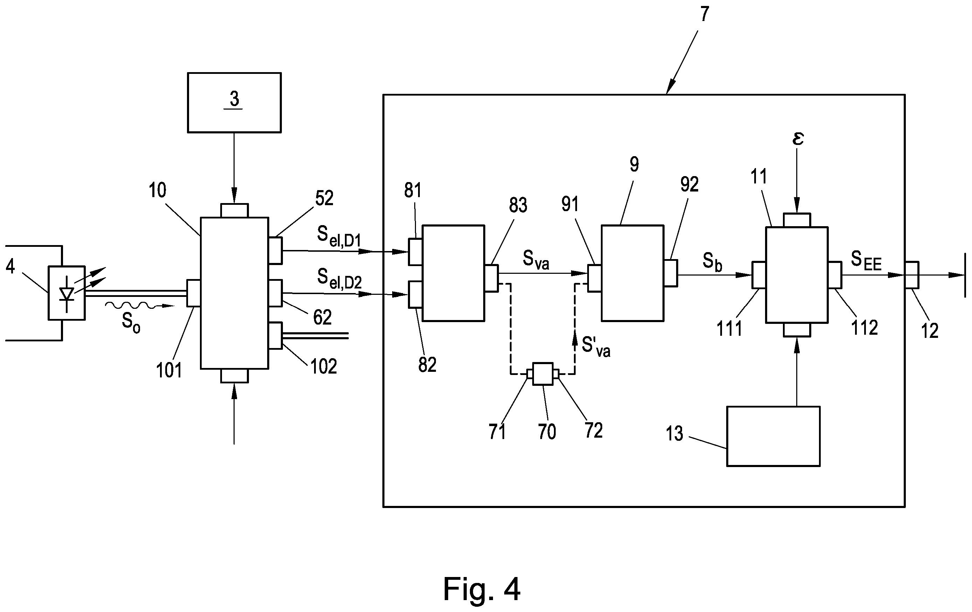

Eine derartige Umwandlungseinheit kann einen modularen Aufbau aufweisen. Im Folgenden werden anhand der Fig. 3 und Fig. 4 verschiedene Ausführungsbeispiele einer Umwandlungseinheit 7 einer erfindungsgemäßen Anordnung 100 beschrieben:

So kann die Umwandlungseinheit 7 einen Transimpedanzverstärker 8 umfassen, wie er schematisch in Fig. 4 dargestellt ist. Der Transimpedanzverstärker 8 weist einen ersten elektrischen Transimpendanzverstärker-Eingang 81, einen zweiten elektrischen Transimpedanzverstärker-Eingang 82 und einen elektrischen Transimpedanzverstärker-Ausgang 83 auf. Der elektrische Monitorphotodiodenausgang 52 der Monitorphotodiode 5 ist an den ersten elektrischen Transimpendanzverstärker-Eingang 81 angeschlossen und der elektrische Monitorphotodiodenausgang 62 der weiteren Monitorphotodiode 6 ist an den zweiten elektrischen Transimpendanzverstärker-Eingang 82 angeschlossen. Der Transimpedanzverstärker-Ausgang 83 kann dabei optional den Ausgang der Umwandlungseinheit 7, d.h. den Zufallsausgang 12 der Anordnung 100, bilden.

Die Umwandlungseinheit 7 kann, wie in Fig. 4, optional zusätzlich auch eine analoge Signalverarbeitungseinheit 70 mit einem elektrischen Eingang 71 und einem elektrischen Ausgang 72 umfassen. Ist eine derartige analoge Signalverarbeitungseinheit 70 vorhanden, ist der elektrische Transimpedanzverstärker-Ausgang 83 an den elektrischen Eingang 71 der analogen Signalverarbeitungseinheit 70 angeschlossenen und der elektrische Ausgang 72 der analogen Signalverarbeitungseinheit 70 kann den Ausgang der Umwandlungseinheit 7, d.h. den Zufallsausgang 12 der Anordnung 100, bilden.

Die Umwandlungseinheit 7 kann, wie in Fig. 4, optional auch einen Analog-Digital-Wandler 9 umfassen. Ein derartiger Analog-Digital-Wandler 9 weist einen elektrischen Wandlereingang 91 und einen elektrischen Wandlerausgang 92 auf, der den Ausgang der Umwandlungseinheit 7, d.h. den Zufallsausgang 12 der Anordnung 100, bilden kann. Umfasst die Umwandlungseinheit 7 einen derartigen Analog-Digital-Wandler 9, so kann einerseits der elektrische Transimpedanzverstärker-Ausgang 83 unmittelbar an den elektrischen Wandlereingang 91 angeschlossen sein. Andererseits ist es auch möglich, sollte die Umwandlungseinheit 7 eine analoge Signalverarbeitungseinheit 70 umfassen, dass der elektrische Ausgang 72 der analogen Signalverarbeitungseinheit 70 an den elektrischen Wandlereingang 91 angeschlossenen ist.

Die Umwandlungseinheit 7 kann, wie in Fig. 4, optional zusätzlich auch eine digitale Signalverarbeitungseinheit 11 umfassen. Eine derartige digitale Signalverarbeitungseinheit 11 weist einen elektrischen Signaleingang 111 und einen elektrischen Signalausgang 112 auf, der optional als Ausgang der Umwandlungseinheit 7 dienen und den Zufallsausgang 12 der Anordnung 100 bilden kann. Im Fall, dass eine derartige digitale Signalverarbeitungseinheit 11 vorgesehen ist, kann der elektrische Wandlerausgang 92 an den elektrischen Signaleingang 111 der digitalen Signalverarbeitungseinheit 11 angeschlossen sein.

Die Umwandlungseinheit 7 kann, wie in Fig. 4, optional zusätzlich auch einen Entropieschätzer 13 umfassen, der aus dem bekannten Verhalten der optischen Komponenten der Anordnung 100 und der elektrischen Komponenten der Anordnung 100 eine Entropie des am elektrischen Wandlerausgang 92 bereitgestellten binären Zufallssignals $S_b$ berechnen und zur Verfügung halten kann. Optional können zusätzlich zur Berücksichtigung des optischen Verhaltens auch Parameter wie die Entropiezahl $\varepsilon$ vorgegeben und bei der Berechnung der Entropie berücksichtigt werden. Der Entropieschätzer 13 kann z.B. in die digitale Signalverarbeitungseinheit 11 integriert oder an diese angeschlossen sein.

Bei den optischen Komponenten, kann es sich, wie zuvor beschrieben, um die optische Quelle 4 und/oder die jeweilige Monitorphotodiode 5, 6 und/oder den polarization-multiplexed in-phase/quadrature Modulator 10 selbst handeln, während es sich bei den elektrischen Komponenten um die zumindest eine Steuereinheit 3 und/oder den Transimpedanzverstärker 8 und/oder den Analog-Digital-Wandler 9 handeln kann.

Wie im zweiten Ausführungsbeispiel einer erfindungsgemäßen Anordnung 100, dargestellt in Fig. 3, kann der optische Ausgang 15 des nested Mach-Zehnder-Modulators 1 optional an den Eingang 181 eines internen Strahlteilers 18 geführt sein. Ein erster optischer Ausgang 182 des internen Strahlteilers 18 ist bei der erfindungsgemäßen Anordnung 100 in Fig. 3 an den optischen Monitorphotodiodeneingang 51 der Monitorphotodiode 5 angeschlossen. Dies ist jedoch nicht zwingend erforderlich. Alternativ dazu könnte der optische Ausgang 15 des nested Mach-Zehnder-Modulators 1 auch unmittelbar an den optischen Monitorphotodiodeneingang 51 der Monitorphotodiode 5 angeschlossen sein.

Wie im zweiten Ausführungsbeispiel in Fig. 3 kann auch der optische Ausgang 22 des weiteren nested Mach-Zehnder-Modulators 2 optional an den Eingang 191 eines weiteren internen Strahlteilers 19 geführt sein. Ein erster optischer Ausgang 192 des weiteren internen Strahlteilers 19 ist an den optischen Monitorphotodiodeneingang 61 der weiteren Monitorphotodiode 6 angeschlossen. Dies ist jedoch nicht zwingend erforderlich. Alternativ dazu könnte der optische Ausgang 22 des weiteren nested Mach-Zehnder-Modulators 2 auch unmittelbar an den optischen Monitorphotodiodeneingang 61 der weiteren Monitorphotodiode 6 angeschlossen sein.

Beim Ausführungsbeispiel in Fig. 3 wird das optische Signal $S_o$ am Eingang 101 des polarization-multiplexed in-phase/quadrature Modulators 10 am Eingangsstrahlteiler 40 verzweigt bzw. gesplittet, idealerweise genau in einen Verhältnis 50/50, und an den nested Mach-Zehnder-Modulator 1 und den weiteren nested Mach-Zehnder-Modulator 2 weitergeleitet. Die 50/50 Verteilung ist besonders günstig, damit im Falle der Differenzbildung der Gleichspannungsanteil vollständig unterdrückt wird um eine Sättigung der nachfolgenden Stufe zu verhindern. Dementsprechend soll auch der Anteil $S_{o,M1}$ des vom nested Mach-Zehnder-Modulator 1 bereitgestellten optischen Signals, der an die Monitorphotodiode 5 weitergeleitet wird, dem Anteil $S_{o,M2}$ des vom weiteren nested Mach-Zehnder-Modulator 2 bereitgestellten optischen Signals, der an die weitere Monitorphotodiode 6 weitergeleitet wird, entsprechen.

Da es zu Verlusten im jeweiligen nested Mach-Zehnder-Modulator 1, 2 kommen kann, kann es schwierig zu erreichen sein, dass nach der Verzweigung bzw. Splittung des optischen Signals $S_o$ in einem Verhältnis 50/50, anschließend auch der Anteil $S_{o,M1}$ des vom nested Mach-Zehnder-Modulator 1 bereitgestellten optischen Signals, der an die Monitorphotodiode 5 weitergeleitet wird, dem Anteil $S_{o,M2}$ des vom weiteren nested Mach-Zehnder-Modulator 2 bereitgestellten optischen Signals, der an die weitere Monitorphotodiode 6 weitergeleitet wird, entspricht.

Weiters kann die Ungenauigkeit z.B. eines Tap-Couplers (z.B. eines internen Strahlteilers vor einer Monitorphotodiode) oder eines anderen Strahlteilers bzw. Splitters, zu einer ungleichen Teilung des optischen Signals bzw. einem Ungleichgewicht der Anteile $S_{o,M1}$, $S_{o,M2}$ des vom jeweiligen nested Mach-Zehnder-Modulator 1, 2 bereitgestellten optischen Signals, der an die Monitorphotodiode 5, 6 weitergeleitet wird, führen. Ein derartiger Tap-Coupler kann z.B. als interner Strahlteiler 18, 19 z.B. am jeweiligen Ausgang 15, 22 des jeweiligen nested Mach-Zehnder-Modulators 1, 2 angeordnet sein und z.B. 10% des optischen Signals, das den nested Mach-Zehnder-Modulator 1, 2 verlässt, zu den Monitorphotodioden 5, 6 abzweigen.

Weiters kann ein ungenaues Teilerverhältnis bereits am Eingangs-Strahlteiler 40 dazu führen, dass das optische Signal $S_o$ in einem Verhältnis ungleich 50/50 geteilt wird. In diesen Fällen muss eine Kompensation dieser ungleichen Verteilung durchgeführt werden. Dies kann erzielt werden, indem die nested Mach-Zehnder-Modulatoren 1, 2 als variable Abschwächer verwendet werden.

Dazu werden die Arbeitspunkte der nested Mach-Zehnder-Modulatoren 1, 2 von der Steuereinheit 3 so eingestellt, dass der Gleichanteil der Photodiodenströme, d.h. der elektrischen Signale $S_{el,D1}$, $S_{el,D2}$, an den Monitorphotodiodenausgängen 52, 62 der Monitorphotodioden 5, 6 gleich wird. Die zuvor bereits beschriebene interferometrische Anordnung der nested Mach-Zehnder-Modulatoren 1, 2 erlaubt dies, da hier Leistung abgeschwächt werden kann. In der Regel kann aber nicht beliebig viel abgeschwächt bzw. vernichtet werden, da der Gleichanteil der Photodiodenströme groß sein soll. Je höher der Gleichanteil der Photodiodenströme ist, umso höher ist die Varianz des Zufallssignals und damit auch die Generierungsrate der Zufallszahlen. Zudem wird darauf geachtet, dass der hohe Photodiodenstrom keine Sättigung der Monitorphotodiode bewirkt.

Vorzugsweise wird daher die Leistung an den beiden optischen Ausgängen 15, 22 der nested Mach-Zehnder-Modulatoren 1, 2 maximiert und anschließend der stärkere optische Ausgang 15, 22 der beiden nested Mach-Zehnder-Modulatoren 1, 2 durch eine Abänderung des Arbeitspunktes ein wenig abgeschwächt, um ihn dem geringfügig schwächeren optischen Ausgang 15, 22 anzugleichen. Der Abgleich erfolgt wiederum gemäß der Gleichanteile der Photodiodenströme an den Monitorphotodiodenausgängen 52, 62 der Monitorphotodioden 5, 6, die gleich sein sollen. Je nach Auslegung der nested Mach-Zehnder-Modulatoren 1, 2 kann die jeweilige Monitorphotodiode 5, 6 durch einen internen Strahlteiler 18, 19, z.B. einen Tap-Koppler, der typischerweise 10% zur Monitorphotodiode 5, 6 abzweigt, angespeist werden.

Optional ist es, wie im ersten Ausführungsbeispiel auch möglich, dass die Monitorphotodioden 5, 6 durch den komplementären Mach-Zehnder-Interferometer-Ausgang des jeweiligen nested Mach-Zehnder-Modulators 1, 2 angespeist werden. Wie zuvor bereits beschrieben, stellt jedes Mach-Zehnder-Interferometer $MZI_{1,a}$, $MZI_{1,b}$ zwei Ausgänge bereit, die komplementär wirken, d.h. ein Ausgang erfährt konstruktive, der andere destruktive Interferenz, wie dies bereits zuvor beschrieben wurde. Im Fall, dass die jeweilige Monitorphotodiode 5, 6 am komplementären Ausgang angeschlossen ist, steht der jeweils andere, optische Ausgang des jeweiligen Mach-Zehnder-Interferometers $MZI_{1,a}$, $MZI_{1,b}$ des jeweiligen nested Mach-Zehnder-Modulators 1, 2 z.B. für Datenübertragung komplementär zum Eingang 51, 61 der jeweiligen Monitorphotodiode 5, 6 zur Verfügung.

In diesem Fall werden die Arbeitspunkte der nested Mach-Zehnder-Modulatoren 1, 2 so eingestellt, dass am optischen Ausgang des jeweiligen Mach-Zehnder-Interferometer $MZI_{1,a}$, $MZI_{1,b}$ minimale Leistung abgegeben wird, sodass am Monitorphotodiodeneingang 51, 61 der jeweiligen Monitorphotodiode 5, 6 maximale Leistung auftritt, da die beiden Ausgänge der Mach-Zehnder-Interferometer $MZI_{1,a}$, $MZI_{1,b}$ komplementär, also gegenläufig ausgebildet sind.

Zur Bereitstellung eines verstärkten, analogen Zufallssignals $S_{va}$ werden die an den Monitorphotodiodenausgängen 52, 62 der Monitorphotodiode 5, 6 anliegenden elektrischen Signale $S_{el,D1}$, $S_{el,D2}$ anschließend verknüpft. Der Transimpedanzverstärker 8 bildet dazu im zweiten Ausführungsbeispiel, eine Funktion, z.B. die Differenz, der an den elektrischen Monitorphotodiodenausgängen 52, 62 der Monitorphotodioden 5, 6 anliegenden elektrischen Signale $S_{el,D1}$, $S_{el,D2}$ und verstärkt diese.

Der Transimpedanzverstärker 8 verstärkt also die Differenz der beiden elektrischen Signale $S_{el,D1}$, $S_{el,D2}$, d.h. die Monitorphotodiodenströme der Monitorphotodioden 5, 6. Da die Gleichanteile der elektrischen Signale $S_{el,D1}$, $S_{el,D2}$ gleich sind, werden die Gleichanteile der beiden elektrischen Signale $S_{el,D1}$, $S_{el,D2}$ bei der Differenzbildung entfernt. Allerdings besitzen die elektrischen Signale $S_{el,D1}$, $S_{el,D2}$ der Monitorphotodioden 5, 6, d.h. deren Monitorphotodiodenströme, auch einen Wechselanteil, der dem Quantenrauschen der optischen Quelle 4, z.B. eines Lasers, entspricht.

Dieser Wechselanteil wird nun verstärkt und steht nun als verstärktes elektrisches "Quellsignal" zur Zufallszahlengenerierung zur Verfügung. Auf diese Weise wird also ein verstärktes, analoges Zufallssignal $S_{va}$ am Transimpedanzverstärker-Ausgang 83 bereitgestellt. Sofern der Transimpedanzverstärker-Ausgang 83 den Ausgang der Umwandlungseinheit 7 bildet, wird dieses verstärkte, analoge Zufallssignal $S_{va}$ am Zufallsausgang 12 der Anordnung 100 bereitgestellt.

Im zweiten Ausführungsbeispiel einer erfindungsgemäßen Anordnung 100 wird das verstärkte, analoge Zufallssignal $S_{va}$ dem elektrischen Eingang 71 der analogen Signalverarbeitungseinheit 70 zugeführt.

Diese analoge Signalverarbeitungseinheit 70 dient dazu, die Signalqualität des verstärkten, analogen Zufallssignals $S_{va}$, z.B. vor einer etwaigen Digitalisierung, noch weiter zu verbessern. Dazu kann die analoge Signalverarbeitungseinheit 70 das am Transimpedanzverstärker-Ausgang 83 bereitgestellte verstärkte, analoge Zufallssignal $S_{va}$ z.B. filtern. Auf diese Weise können z.B. ungewollte Störungen oder allfällige Artefakte des I/Q-Transmitters wie Pilottöne, die für den Datenbetrieb benötigt werden, herausgefiltert werden. Derartige spektralen Komponenten würden etwa die effektive Zahl an Bits, mit welcher die Digitalisierung des Rauschsignals erfolgen kann, vermindern, da durch die im Allgemeinen starken Störsignale der Aussteuerbereich verringert und folglich das im Allgemeinen schwächere Rauschsignal nur mit geringerer Auflösung digitalisiert wird.

Sofern der elektrische Ausgang 72 der analogen Signalverarbeitungseinheit 70 den Ausgang der Umwandlungseinheit 7, d.h. den Zufallsausgang 12 der Anordnung 100 bildet, wird dieses gefilterte verstärkte, analoge Zufallssignal $S'_{va}$ am Zufallsausgang 12 bereitgestellt.

Im zweiten Ausführungsbeispiel, dargestellt in Fig. 3 und Fig. 4, umfasst die Umwandlungseinheit 7 eine derartige analoge Signalverarbeitungseinheit 70 und das gefilterte verstärkte, analoge Zufallssignal $S'_{va}$ wird dem Wandlereingang 91 des Analog-Digital-Wandlers 9 zugeführt. Sofern die Umwandlungseinheit 7 keine derartige analoge Signalverarbeitungseinheit 70 umfasst, wird das verstärkte, analoge Zufallssignal $S_{va}$ des Transimpedanzverstärkers 8 ohne Filterung unmittelbar dem Wandlereingang 91 des Analog-Digital-Wandlers 9 zugeführt.

Der Analog-Digital-Wandlers 9 wandelt das elektrische analoge Quellsignal, d.h. das verstärkte, analoge Zufallssignal $S_{va}$, das gegebenenfalls auch gefiltert sein kann, in ein digitales, binäres Zufallssignal $S_b$ um. Dieses binäre Zufallssignal $S_b$ stellt der Analog-Digital-Wandlers 9 am elektrischen Wandlerausgang 92 bereit. Falls der elektrische Wandlerausgang 92 den Zufallsausgang 12 der Umwandlungseinheit 7 bildet, wird dieses binäre Zufallssignal $S_b$ am Zufallsausgang 12 der Anordnung 100 bereitgestellt.

Die Auflösung des Analog-Digital-Wandlers 9 beträgt vorzugsweise mindestens 1 bit. Der genaue Wert der Auflösung (bit am ADC Ausgang) kann an die gewünschte Rate an Zufallszahlen angepasst werden. Alternative kann die Auflösung sehr niedrig gewählt werden, um Komplexität zu reduzieren. Dies kann im Extremfall zu einer einfachen Komparator-Lösung mit 1 bit Auflösung führen. Der Wandlerausgang 92 kann die digitalen Daten auf einer Leitung seriell ausgeben oder auf mehreren Leitungen parallel.

Der Analog-Digital-Wandler 9 kann vorteilhafterweise über eine Abtasteinheit - Sample & Hold - verfügen, um das analoge Quellsignal für kurze Zeit konstant zu halten. Die Zeitpunkte können von einer Wandler-Steuereinheit definiert werden, die im Analog-Digital-Wandler 9 integriert sein kann. Eine Möglichkeit besteht darin, dass die Wandler-Steuereinheit ein periodisches Signal erzeugt, damit das gefilterte, verstärkte, analoge Zufallssignal $S'_{va}$ periodisch abgetastet wird. Die Wandler-Steuereinheit kann von der Entropieschätzung instruiert werden. Die Entropieschätzung kann die Abtastperiode (bzw. Abtastfrequenz) z.B. in Abhängigkeit vom gefilterten Fourierspektrum des Rauschsignals so vorgeben, dass die geschätzte Entropie maximiert wird. Das Ausgangssignal der Abtasteinheit wird dem Quantisierer des Analog-Digital-Wandlers 9 zugeführt. Da ein Analog-Digital-Wandler keine sofortige Wandlung durchführen kann, sollte der Eingabewert während der Zeit, in der der Wandler eine Wandlung durchführt, idealerweise konstant gehalten werden (als Konvertierungszeit bezeichnet). Eine als Abtasteinheit bezeichnete Eingangsschaltung führt diese Aufgabe aus. Danach wird dieses kurzzeitig konstante Signal dem Quantisierer des Wandlers zugeführt, damit die eigentliche Wandlung erfolgen kann.

In Fig. 4 ist der elektrische Wandlerausgang 92 an die digitale Signalverarbeitungseinheit 11 angeschlossen. Die digitale Signalverarbeitungseinheit 11 erstellt aus dem am elektrische Wandlerausgang 92 bereitgestellten binären Zufallssignal $S_b$ ein binäres Zufallssignal $S_{EE}$, insbesondere eine Zufallszahl, mit verbesserten statistischen Eigenschaften, hier konkret erhöhter Entropie pro bit. "Erhöhte Entropie pro bit" ist hier so zu verstehen, dass das binäre Zufallssignal $S_{EE}$, das von der digitalen Signalverarbeitungseinheit 11 erzeugt und an ihrem elektrischen Signalausgang 112 bereitgestellt wird, im Vergleich zum binären Zufallssignal $S_b$ des Analog-Digital-Wandlers 9 erhöhte Entropie pro bit aufweist. Dies kann auf verschiedene Weise erzielt werden: Wie zuvor bereits erwähnt, verfügt die digitale Signalverarbeitungseinheit 11 im zweiten Ausführungsbeispiel über einen Entropieschätzer 13. Der Entropieschätzer errechnet aus dem bekannten Verhalten der optischen Komponenten der Anordnung 100 und der elektrischen Komponenten der Anordnung 100 eine Entropie des am elektrischen Wandlerausgang 92 bereitgestellten binären Zufallssignals $S_b$. Hierbei kann der Entropieschätzer 13 z.B. die Shannon-Entropie, eine Renyi-Entropie, oder die Min-Entropie wie in Miguel Herrero-Collantes, Juan Carlos Garcia-Escartin, "Quantum Random Number Generators", Reviews of Modern Physics 89, 015004 (2017), oder Tomamichel, Marco, "Quantum Information Processing with Finite Resources", Springer, Mathematical Foundations, ISBN 978-3-319-21891-5, beschrieben, oder auch eine bedingte Entropie, wie die bedingte Shannon-Entropie, eine bedingte Renyi-Entropie oder eine bedingte Min-Entropie (wobei die Bedingung jeweils z.B. die vorhandene Information eines möglichen Angreifers, z.B. betreffend Verstärker-Eigenschaften sein kann), wie ebenfalls in Miguel Herrero-Collantes, Juan Carlos Garcia-Escartin, "Quantum Random Number Generators", Reviews of Modern Physics 89, 015004 (2017), oder Tomamichel, Marco, "Quantum Information Processing with Finite Resources", Springer, Mathematical Foundations, ISBN 978-3-319-21891-5, beschrieben, des am elektrischen Wandlerausgang 92 bereitgestellten binären Zufallssignals $S_b$ berechnen und für die digitale Signalverarbeitungseinheit 11 zur Verfügung zu halten.

Optional können zusätzlich zur Berücksichtigung des optischen Verhaltens auch Parameter wie $\varepsilon$, das den statistischen Abstand der erzeugten Zufallszahlen von der Gleichverteilung charakterisiert, vorgegeben und bei der Berechnung der Entropie berücksichtigt werden. So kann der Entropieschätzer 13 z.B. eine parametrisierte Entropie, wie die $\varepsilon$-smooth Min-Entropie (siehe Miguel Herrero-Collantes, Juan Carlos Garcia-Escartin, "Quantum Random Number Generators", Reviews of Modern Physics 89, 015004 (2017) , oder Tomamichel, Marco, "Quantum Information Processing with Finite Resources", Springer, Mathematical Foundations, ISBN 978-3-319-21891-5), oder eine parametrisierte bedingte Entropie, insbesondere die bedingte $\varepsilon$-smooth Min-Entropie (siehe ebenfalls Miguel Herrero-Collantes, Juan Carlos Garcia-Escartin, "Quantum Random Number Generators", Reviews of Modern Physics 89, 015004 (2017), oder Tomamichel, Marco, "Quantum Information Processing with Finite Resources", Springer, Mathematical Foundations, ISBN 978-3-319-21891-5), des am elektrischen Wandlerausgang 92 bereitgestellten binären Zufallssignals $S_b$ berechnen und für die digitale Signalverarbeitungseinheit 11 zur Verfügung zu halten.

Verfügt der Analog-Digital-Wandler 9 über eine Abtasteinheit und eine Wandler-Steuereinheit, benötigt der Entropieschätzer 13 zusätzlich Informationen darüber, welches Signal die Wandler-Steuereinheit erzeugt, um die Entropie des am elektrischen Wandlerausgang 92 bereitgestellten binären Zufallssignals $S_b$ berechnen zu können.

Steht ein derartiger Entropieschätzer 13 zur Verfügung, zieht die digitale Signalverarbeitungseinheit 11 die vom Entropieschätzer 13 bestimmte Entropie heran, um eine Zufallsvariable mit definierter Entropie pro bit bzw. mit definiertem Minimumwert für eine Entropie pro bit bzw. Block oder mit definiertem Minimumwert für den statistischen Abstand zur Gleichverteilung oder mit definiertem Minimumwert für den statistischen Abstand zu einer anderen gewünschten Wahrscheinlichkeitsverteilung bereitzustellen. Die digitale Signalverarbeitungseinheit 11 kann einerseits das Ausgangssignal des Analog-Digital-Wandlers 9, d.h. das am elektrischen Wandlerausgang 92 bereitgestellte binäre Zufallssignal $S_b$, und das Ausgangssignal des Entropieschätzers 13 zu einem Strom von digitalen Zufallszahlen mit garantierter Entropie verarbeiten. Die digitale Signalverarbeitungseinheit 11 kann hierzu bekannte Zufallszahlextraktionsverfahren wie z.B. einen von Neumann Extraktor (beschreiben z.B. in , John von Neumann, "Various Techniques Used in Connection With Random Digits" J. Res. Nat. Bur. Stand. Appl. Math. Series 3, 36-38 (1951)) verwenden.

Die zugrundeliegende Zufallsvariable, der so bestimmten Zufallszahl, hat vorzugsweise eine Entropie möglichst nahe an 1 bit pro bit bzw. ist deren Verteilung statistisch möglichst nahe an der Gleichverteilung oder einer anderen gewünschten Verteilung. Dies ist notwendig damit die Zufallszahl in der Kryptographie und überall dort wo eine konkrete Verteilung benötigt wird, eingesetzt werden kann.

Die Zufallszahl stellt die digitale Signalverarbeitungseinheit 11 schließlich an ihrem elektrischen Signalausgang 112, im zweiten Ausführungsbeispiel ist dies der Zufallsausgang 12 der Anordnung 100, als Zufallszahl bereit.

Optional ist es auch möglich, dass zusätzlich einmalig eine Zufallszahl, die der digitalen Signalverarbeitungseinheit 11 bereitgestellt oder in der digitalen Signalverarbeitungseinheit 11 vorab gespeichert wird, für das Zufallszahlextraktionsverfahren herangezogen wird. Dies kann der Fall sein, wenn die digitale Signalverarbeitungseinheit 11 Universal Hashing (z.B. Toeplitz Hashing) (Universal Hashing beschrieben z.B. in Carter, Larry; Wegman, Mark N., "Universal Classes of Hash Functions". Journal of Computer and System Sciences. 18 (2), 143-154 (1979).. Toeplitz hashing beschreiben z.B. in Mansour, Y., N. Nisan and P. Tiwari, "The computational complexity of universal hashing", Theoretical Computer Science 107, 121-133 (1993)) für die Erstellung von digitalen Zufallszahlen mit garantierter Entropie heranzieht. Denkbar ist auch, dass diese Zufallszahl über eine externe Schnittstelle bereitgestellt wird.

## Drittes Ausführungsbeispiel einer erfindungsgemäßen Anordnung 100

Im Folgenden wird ein besonders einfach aufgebautes drittes Ausführungsbeispiel einer erfindungsgemäßen Anordnung 100 beschrieben. Im dritten Ausführungsbeispiel weist der polarization-multiplexed in-phase/quadrature Modulator 10 nur einen einzelnen nested Mach-Zehnder-Modulator 1 auf.

Der optische Eingang 14 des nested Mach-Zehnder-Modulators 1 ist direkt dem optischen Modulatoreingang 101 nachgeschaltet. Die optische Quelle 4 kann dabei beispielsweise unmittelbar auf den optischen Eingang 14 des nested Mach-Zehnder-Modulators 1 gerichtet, bzw. an diesen geführt sein. In diesem Fall wird das optische Signal $S_o$ also ohne gesplittet bzw. verzweigt zu werden, an den optischen Eingang 14 des nested Mach-Zehnder-Modulators 1 geleitet.

Über den elektrischen Eingang 16 des nested Mach-Zehnder-Modulators 1 werden, wie im ersten und zweiten Ausführungsbeispiel einer erfindungsgemäßen Anordnung 100, von einer Steuereinheit 3 die elektrischen Signale vorgegeben, mit denen der Arbeitspunkt des nested Mach-Zehnder-Modulators 1 eingestellt wird.

Eine Monitorphotodiode 5 ist dem polarization-multiplexed in-phase/quadrature Modulator 10 nachgeschaltet. Die Monitorphotodiode 5 kann hier direkt dem optischen Ausgang 15 des nested Mach-Zehnder-Modulators 1 nachgeschaltet sein, oder über einen internen Strahlteiler 18 dem optischen Ausgang 15 des nested Mach-Zehnder-Modulators 1 nachgeschaltet sein. Optional ist es auch möglich, dass die Monitorphotodiode 5 auch einem zum Datenausgang des jeweiligen Mach-Zehnder-Interferometers $MZI_{1,a}$, $MZI_{1,b}$ komplementären Ausgang angeschlossen ist, wie dies schematisch in Fig. 1 angedeutet ist.

Wie zuvor bereits beschrieben, weist die Monitorphotodiode 5 einen elektrischen Monitorphotodiodenausgang 52 auf, der einen Zufallsausgang 12 der Anordnung 100 bildet. An diesem Zufallsausgang 12 wird ein erzeugtes Zufallssignal, insbesondere erzeugte Zufallszahlen, bereitgestellt.

Im einfachsten Ausführungsbeispiel eines erfindungsgemäßen Verfahrens zur Erzeugung eines Zufallssignals mit der Anordnung 100 des ersten Ausführungsbeispiels wird ein unmoduliertes, optisches Signal $S_o$ durch die optische Quelle 4, z.B. einem Laser, in den polarization-multiplexed in-phase/quadrature Modulator 10 eingespeist und an den nested Mach-Zehnder-Modulator 1 weitergeleitet. Durch den nested Mach-Zehnder-Modulator 1 wird das optische Signal $S_o$ entsprechend dem vorgegebenen Arbeitspunkt moduliert.

Wie bereits zuvor beschrieben, wird zur Erzeugung eines Zufallssignals zumindest ein Anteil $S_{o,M1}$ des vom nested Mach-Zehnder-Modulator 1 bereitgestellten optischen Ausgangssignals an die Monitorphotodiode 5 weitergeleitet und in ein elektrisches Signal $S_{el,D1}$ umgewandelt. Am elektrischen Monitorphotodiodenausgang 52 der Monitorphotodiode 5 liegt somit schließlich ein elektrisches Signal $S_{el,D1}$ an. Dieses elektrische Signal $S_{el,D1}$ stellt ein Zufallssignal dar, aufgrund des inhärent zufälligen Charakters des von der optischen Quelle 4 eingespeisten optischen Signals $S_o$. Somit bildet der elektrische Monitorphotodiodenausgang 52 der Monitorphotodiode 5 einen Zufallsausgang 12 der Anordnung 100.

**Gleichzeitiges Erzeugen eines Zufallssignals und Senden von Daten:**

Wie bereits zuvor erwähnt, ist es vorteilhafterweise möglich, dass eine Monitorphotodiode 5, 6 durch einen, zum Datenausgang des jeweiligen Mach-Zehnder-Interferometers $MZI_{1,a}$, $MZI_{1,b}$ komplementären, Mach-Zehnder-Interferometer-Ausgang des jeweiligen nested Mach-Zehnder-Modulators 1, 2 angespeist werden kann, wie bereits zuvor beschrieben wurde. Wie zuvor bereits beschrieben, stellt jedes Mach-Zehnder-Interferometer $MZI_{1,a}$, $MZI_{1,b}$ zwei Ausgänge bereit, die komplementär wirken, d.h. ein Ausgang erfährt konstruktive, der andere destruktive Interferenz. Im Fall, dass die jeweilige Monitorphotodiode 5, 6 am komplementären Ausgang angeschlossen ist, steht der optische Ausgang 15, 22 des jeweiligen nested Mach-Zehnder-Modulators 1, 2 z.B. für Datenübertragung komplementär zum Eingang 51, 61 der jeweiligen Monitorphotodiode 5, 6 zur Verfügung.

So können einerseits abwechselnd Daten über den Datenausgang 102 des polarization-multiplexed in-phase/quadrature Modulators 10 übertragen und Zufallszahlen generiert und am Zufallsausgang 12 bereitgestellt werden. Der Datenausgang 102 des polarization-multiplexed in-phase/quadrature Modulators 10 ist dabei den Datenausgängen der nested Mach-Zehnder-Modulatoren 1, 2 nachgeschaltet, wie dies in Fig. 3 ersichtlich ist.

Der polarization-multiplexed in-phase/quadrature Modulator 10 kann dazu zwei Betriebszustände aufweisen, nämlich einen ersten Betriebszustand, in dem ein Datensignal über den optischen Datenausgang 102 des polarization-multiplexed inphase/quadrature Modulators 10 übertragen wird und einen zweiten Betriebszustand, in dem ein Zufallssignal, insbesondere Zufallszahlen, wie zuvor beschrieben, erzeugt werden. Zwischen den beiden Betriebszuständen kann gewechselt werden, indem der Arbeitspunkt des polarization-multiplexed in-phase/quadrature Modulators 10 geändert wird. Dies erfolgt in einfachster Form gemäß einem Zeitmultiplex, d.h., die zwei Arbeitspunkteinstellungen wechseln sich zeitlich gemäß einer vorgegebener zeitlichen Folge ab. Diese Folge kann gemäß dem Duty Cycle entweder die Datenübertragung oder die Generierung von Zufallszahlen zeitlich bevorzugen. Das Wechseln zwischen den Arbeitspunkteinstellungen erfolgt dabei durch ein geeignetes elektrisches Ansteuern an den elektrischen Eingängen 16, 23 der nested Mach-Zehnder-Modulatoren 1,2.

Optional können die beiden Betriebszustände auch gleichzeitig genutzt werden, d.h. gleichzeitig Daten übertragen und Zufallszahlen generiert werden. Dazu wird der Frequenzbereich des polarization-multiplexed in-phase/quadrature Modulators 10 vorteilhafterweise so aufgeteilt wird, sodass der Frequenzbereich des Datensignals und der Frequenzbereich des zumindest einen Zufallssignals, insbesondere der Zufallszahlen, einander nicht überlappen. So kann zum Beispiel der niedrige Frequenzbereich unterhalb des typischen Low-Frequency Cut-Offs der Datensignale (im Bereich von z.B. 0 bis 100 kHz) für die Generierung von Zufallszahlen dienen, während die hohen Frequenzen (von 100 kHz bis 25 GHz) der Datenübertragung dienen. Auf diese Weise kann ein Übersprechen zwischen den beiden Signalen unterdrückt werden. Dies kann zum Beispiel durch passive (Einfügen eines Filters) and aktive Filterung (Frequenzgang eines Verstärkers) erreicht werden.

**Patentansprüche**

1. Anordnung (100) zur Erzeugung eines Zufallssignals umfassend

   - eine optische Quelle (4), insbesondere einen Laser,

- einen polarization-multiplexed in-phase/quadrature Modulator (10), der folgende Bestandteile umfasst:

  o einen optischen Modulatoreingang (101), an den die optische Quelle (4) angeschlossen ist,

  o zumindest einen nested Mach-Zehnder-Modulator (1), wobei der zumindest eine nested Mach-Zehnder-Modulator (1) dem optischen Modulatoreingang (101) nachgeschaltet ist und wobei der zumindest eine nested Mach-Zehnder-Modulator (1) einen optischen Ausgang (15) und zumindest einen elektrischen Eingang (16) zur Vorgabe des Realteils und/oder des Imaginärteils eines optischen Signals aufweist,

- eine Steuereinheit (3), die an den elektrischen Eingang (16) des nested Mach-Zehnder-Modulators (1) angeschlossen ist, wobei die Steuereinheit (3) dazu ausgebildet ist, zumindest einen Arbeitspunkt des polarization-multiplexed in-phase/quadrature Modulators (100) vorzugeben,

- wobei zumindest eine Monitorphotodiode (5) dem polarization-multiplexed inphase/quadrature Modulator (10) nachgeschaltet ist, wobei die Monitorphotodiode (5) dem optischen Ausgang (15) des nested Mach-Zehnder-Modulators (1) nachgeschaltet ist und einen elektrischen Monitorphotodiodenausgang (52) aufweist, sodass ein vom nested Mach-Zehnder-Modulator (1) bereitgestelltes optisches Signal in ein elektrisches Signal umwandelbar ist, und

- wobei der Monitorphotodiodenausgang (52) der Monitorphotodiode (5) einen Zufallsausgang (12) der Anordnung (100) zur Bereitstellung eines erzeugten Zufallssignals, bildet, **dadurch gekennzeichnet,**

- **dass** der polarization-multiplexed in-phase/quadrature Modulator (10) zwei Betriebszustände aufweist,

  - wobei der polarization-multiplexed in-phase/quadrature Modulator (10) dazu ausgebildet ist, im ersten Betriebszustand ein Datensignal über den optischen Ausgang (102) des polarization-multiplexed in-phase/quadrature Modulators (10) zu übertragen und
  - im zweiten Betriebszustand das Zufallssignal zu erzeugen, und

- **dass** der polarization-multiplexed in-phase/quadrature Modulator (10) dazu ausgebildet ist, zwischen den beiden Betriebszuständen durch Änderung seines Arbeitspunkts zu wechseln.

2. Anordnung (100) nach Anspruch 1, **dadurch gekennzeichnet,**

  - **dass** der polarization-multiplexed in-phase/quadrature Modulator (10) einen Eingangs-Strahlteiler (17) aufweist, wobei der optische Modulatoreingang (101) an den Eingang (171) des Eingangs-Strahlteilers (17) geführt ist, und wobei ein erster Ausgang (172) des Eingangs-Strahlteilers (40) an den optischen Eingang (14) des nested Mach-Zehnder-Modulators (1) geführt ist und
  - **dass** die Anordnung einen weiteren nested Mach-Zehnder-Modulator (2) umfasst, wobei ein zweiter Ausgang (173) des Eingangs-Strahlteilers (40) an den optischen Eingang (21) des weiteren nested Mach-Zehnder-Modulator (2) geführt ist und wobei der weitere nested Mach-Zehnder-Modulator (2) einen optischen Ausgang (22) und zumindest einen elektrischen Eingang (23) zur Vorgabe des Realteils und/oder des Imaginärteils eines optischen Signals aufweist,

  **dass** die Steuereinheit (3), gegebenenfalls eine weitere Steuereinheit, an den elektrischen Eingang (23) des weiteren nested Mach-Zehnder-Modulators (2) angeschlossen ist,

  **dass** dem polarization-multiplexed in-phase/quadrature Modulator (10) zumindest eine weitere Monitorphotodiode (6) nachgeschaltet ist, wobei die weitere Monitorphotodiode (6) dem optischen Ausgang (22) des weiteren nested Mach-Zehnder-Modulators (2) nachgeschaltet ist und einen elektrischen Monitorphotodiodenausgang (62) aufweist, sodass ein vom weiteren nested Mach-Zehnder-Modulator (2) bereitgestelltes optisches Signal in ein elektrisches Signal umwandelbar ist, und

  **dass** der Monitorphotodiodenausgang (62) der weiteren Monitorphotodiode (6) einen Zufallsausgang (12') der Anordnung (100) zur Bereitstellung eines erzeugten Zufallssignals, insbesondere erzeugter Zufallszahlen, bildet, wobei gegebenenfalls die Steuereinheit (3), und/oder gegebenenfalls die weitere Steuereinheit, dazu ausgebildet ist, die Arbeitspunkte des nested Mach-Zehnder-Modulators (1) und des weiteren nested Mach-Zehnder-Modulators (2) derart vorzugeben, dass der Gleichanteil des Photodiodenstroms der Monitorphotodiode (5) und der weiteren Monitorphotodiode (6) gleich ist.

3. Anordnung (100) nach einem der vorangehenden Ansprüche, **dadurch gekennzeichnet,**

- **dass** die Anordnung (100) einen internen Strahlteiler (18) umfasst, wobei ein erster optischer Ausgang (182) des internen Strahlteilers (18) an den optischen Monitorphotodiodeneingang (51) der Monitorphotodiode (5) angeschlossen ist und/oder
- **dass** die Anordnung (100) einen weiteren internen Strahlteiler (19) umfasst, wobei ein erster optischer Ausgang (192) des weiteren internen Strahlteilers (19) an den optischen Monitorphotodiodeneingang (61) der weiteren Monitorphotodiode (6) angeschlossen ist.

4. Anordnung nach einem der Ansprüche 2 oder 3, **dadurch gekennzeichnet, dass** der elektrische Monitorphotodiodenausgang (52) der Monitorphotodiode (5) und der elektrische Monitorphotodiodenausgang (62) der weiteren Monitorphotodiode (6) an eine Umwandlungseinheit (7) angeschlossen sind, wobei der Ausgang der Umwandlungseinheit (7) den Zufallsausgang (12) der Anordnung (100) bildet,

- dass die Umwandlungseinheit (7) insbesondere einen Transimpedanzverstärker (8) umfasst,

wobei der Transimpedanzverstärker (8) einen ersten elektrischen Transimpendanzverstärker-Eingang (81), einen zweiten elektrischen Transimpendanzverstärker-Eingang (82) und einen elektrischen Transimpedanzverstärker-Ausgang (83) aufweist,
wobei der elektrische Monitorphotodiodenausgang (52) der Monitorphotodiode (5) an den ersten elektrischen Transimpendanzverstärker-Eingang (81) angeschlossen ist und wobei der elektrische Monitorphotodiodenausgang (62) der weiteren Monitorphotodiode (6) an den zweiten elektrischen Transimpendanzverstärker-Eingang (82) angeschlossen ist,

- dass der Transimpedanzverstärker (8) insbesondere dazu ausgebildet ist, eine Funktion der an den elektrischen Monitorphotodiodenausgängen (52, 62) der Monitorphotodioden (5, 6) anliegenden elektrischen Signale, insbesondere der durch die elektrischen Monitorphotodiodenausgängen (52, 62) der Monitorphotodioden (5, 6) fließenden Ströme, zu bilden und zu verstärken, und derart ein verstärktes, analoges Zufallssignal am Transimpedanzverstärker-Ausgang (83) bereitzustellen, wobei vorzugsweise vorgesehen ist, dass der Transimpedanzverstärker-Ausgang (83) den Ausgang der Umwandlungseinheit (7) bildet, und
- dass der Transimpedanzverstärker (8) insbesondere dazu ausgebildet ist, die Differenz der an den elektrischen Monitorphotodiodenausgängen (52, 62) der Monitorphotodioden (5, 6) anliegenden elektrischen Signale, insbesondere der durch die elektrischen Monitorphotodiodenausgängen (52, 62) der Monitorphotodioden (5, 6) fließenden Ströme, zu bilden.

5. Anordnung nach Anspruch 4, **dadurch gekennzeichnet, dass** die Umwandlungseinheit (7) eine analoge Signalverarbeitungseinheit (70) umfasst, wobei die analoge Signalverarbeitungseinheit (70) einen elektrischen Eingang (71) und einen elektrischen Ausgang (72) aufweist und

wobei der elektrische Transimpedanzverstärker-Ausgang (83) an den elektrischen Eingang (71) der analogen Signalverarbeitungseinheit (70) angeschlossenen ist,
wobei die analoge Signalverarbeitungseinheit (70) dazu ausgebildet ist, das am Transimpedanzverstärker-Ausgang (83) bereitgestellte verstärkte, analoge Zufallssignal zu filtern und am elektrischen Ausgang (72) der analogen Signalverarbeitungseinheit (70) bereitzustellen, wobei insbesondere vorgesehen ist, dass der elektrische Ausgang (72) der analogen Signalverarbeitungseinheit (70) den Ausgang der Umwandlungseinheit (7) bildet, wobei vorzugsweise vorgesehen ist, dass

a) die Umwandlungseinheit (7) einen Analog-Digital-Wandler (9) umfasst, wobei der Analog-Digital-Wandler (9) einen elektrischen Wandlereingang (91) und einen elektrischen Wandlerausgang (92) aufweist und
b) wobei der elektrische Transimpedanzverstärker-Ausgang (83) an den elektrischen Wandlereingang (91) des Analog-Digital-Wandlers (9), insbesondere an den der elektrische Ausgang (72) der analogen Signalverarbeitungseinheit (70), angeschlossenen ist,
c) wobei der Analog-Digital-Wandler (9) dazu ausgebildet ist, auf Grundlage des am Transimpedanzverstärker-Ausgang (83), insbesondere am elektrischen Ausgang (72) der analogen Signalverarbeitungseinheit (70), bereitgestellten verstärkten, analogen Zufallssignal ein binäres Zufallssignal zu erzeugen und am elektrischen Wandlerausgang (92) bereitzustellen, und
d) wobei insbesondere vorgesehen ist, dass der elektrischen Wandlerausgang (92) den Ausgang der Umwandlungseinheit (7) bildet.

6. Anordnung nach einem der Ansprüche 4 oder 5, **dadurch gekennzeichnet, dass** die Umwandlungseinheit (7) eine digitale Signalverarbeitungseinheit (11) umfasst, wobei die digitale Signalverarbeitungseinheit (11) einen elektrischen Signaleingang (111) und einen elektrischen Signalausgang (112) aufweist und

wobei der elektrische Wandlerausgang (92) an den elektrischen Signaleingang (111) der digitalen Signalverarbeitungseinheit (11) angeschlossen ist, und
wobei die digitale Signalverarbeitungseinheit (11) dazu ausgebildet ist, aus dem am elektrische Wandlerausgang (92) bereitgestellten binären Zufallssignal ein binäres Zufallssignal, insbesondere eine Zufallszahl, mit im Vergleich zur Entropie des vom Analog-Digital-Wandler (9) bereitgestellten binären Zufallssignals verbesserten statistischen Eigenschaften zu erzeugen und an ihrem elektrischen Signalausgang (112) bereitzustellen,
wobei insbesondere vorgesehen ist, dass der elektrischen Signalausgang (112) der digitalen Signalverarbeitungseinheit (11) den Ausgang der Umwandlungseinheit (7) bildet,
wobei insbesondere vorgesehen ist,

a) dass die Umwandlungseinheit (7) einen Entropieschätzer (13) umfasst, wobei der Entropieschätzer (13) dazu ausgebildet ist, aus dem bekannten Verhalten der optischen Komponenten der Anordnung (100), insbesondere der optischen Quelle (4) und/oder des polarization-multiplexed in-phase/quadrature Modulators (10), und der elektrischen Komponente der Anordnung (100), insbesondere der Steuereinheit (3) und/oder des Transimpedanzverstärkers (8) und/oder des Analog-Digital-Wandlers (9), eine Entropie, insbesondere die Shannon-Entropie oder die Min-Entropie, oder eine bedingte Entropie, insbesondere die bedingte Shannon-Entropie oder die bedingte Min-Entropie, des am elektrischen Wandlerausgang (92) bereitgestellten binären Zufallssignals zu berechnen und zur Verfügung zu halten, oder
b) dass die Umwandlungseinheit (7) einen Entropieschätzer (13) umfasst, wobei der Entropieschätzer (13) dazu ausgebildet ist, aus dem bekannten Verhalten der optischen Komponenten der Anordnung (200), insbesondere der optischen Quelle (4) und/oder des polarization-multiplexed in-phase/quadrature Modulators (10), und der elektrischen Komponente der Anordnung (200), insbesondere der Steuereinheit (3) und/oder des Transimpedanzverstärkers (8) und/oder des Analog-Digital-Wandlers (9), sowie anhand vorgegebener Parameter, insbesondere anhand einer vorgegebenen unteren Schranke für eine Entropie, eine parametrisierte Entropie, insbesondere die epsilon-smooth Min-Entropie, oder eine parametrisierte bedingte Entropie, insbesondere die bedingte epsilon-smooth Min-Entropie, des am elektrischen Wandlerausgang (92) bereitgestellten binären Zufallssignals zu berechnen und zur Verfügung zu halten, wobei vorzugsweise vorgesehen ist, dass die digitale Signalverarbeitungseinheit (11) dazu ausgebildet ist, die vom Entropieschätzer (13) bestimmte Entropie heranzuziehen, um eine Zufallszahl mit definierter Entropie pro bit, insbesondere mit einer Entropie möglichst nahe an 1 bit pro bit, nach einem Zufallszahlenextraktionsverfahren, insbesondere mittels von Neumann-Extraktion, zu erzeugen und an ihrem elektrischen Signalausgang (112) bereitzustellen.

7. Anordnung nach Anspruch 6, **dadurch gekennzeichnet, dass** die digitale Signalverarbeitungseinheit (11) dazu ausgebildet ist, die vom Entropieschätzer (13) bestimmte Entropie sowie eine vorgegebene, insbesondere in der digitalen Signalverarbeitungseinheit (11) hinterlegte, Zufallszahl heranzuziehen, um eine Zufallszahl mit definierter Entropie pro bit, insbesondere mit einer Entropie möglichst nahe an 1 bit pro bit oder mit einer Verteilung die epsilon-nahe an einer Gleichverteilung ist, nach einem Zufallszahlenextraktionsverfahren, insbesondere mittels Universal Hashing und/oder Toeplitz Hashing, zu erzeugen und an ihrem elektrischen Signalausgang (112) bereitzustellen.

8. Verfahren zur Erzeugung eines Zufallssignals mit einer Anordnung (200), insbesondere nach einem der Ansprüche 1 bis 7, umfassend eine optische Quelle (4) und einen polarization-multiplexed in-phase/quadrature Modulator (10),

- wobei ein optisches Signal ($S_o$) aus der optischen Quelle (4), insbesondere einem Laser, dem optischen Eingang (101) des polarization-multiplexed in-phase/quadrature Modulators (10) zugeführt wird,
- wobei zumindest ein Anteil ($S'_o$) des am optischen Eingang (101) des polarization-multiplexed in-phase/quadrature Modulator (10) einlangenden optischen Signal ($S_o$) an einen nested Mach-Zehnder-Modulator (1) des polarization-multiplexed inphase/quadrature Modulator (10) weitergeleitet wird,
- wobei zumindest ein Anteil ($S_{o,M1}$) des vom nested Mach-Zehnder-Modulator (1) bereitgestellten optischen Ausgangssignals an eine Monitorphotodiode (5) weitergeleitet wird, und

- wobei ein Zufallssignal in Form des am elektrischen Monitorphotodiodenausgang (52) der Monitorphotodiode (5) anliegenden elektrischen Signals ($S_{el,D1}$) bereitgestellt wird,

**dadurch gekennzeichnet,**

**dass** der polarization-multiplexed in-phase/quadrature Modulator (10) zwei Betriebszustände aufweist,

- wobei im ersten Betriebszustand ein Datensignal über den optischen Ausgang (102) des polarization-multiplexed in-phase/quadrature Modulators (10) übertragen wird und
- wobei im zweiten Betriebszustand das Zufallssignal erzeugt wird, und

**dass** zwischen zwei Betriebszuständen gewechselt wird indem der Arbeitspunkt des polarization-multiplexed in-phase/quadrature Modulators (10) geändert wird.

9. Verfahren nach Anspruch 8, **dadurch gekennzeichnet,**

- **dass** ein weiterer Anteil ($S''_o$) des am optischen Eingang (101) des polarization-multiplexed in-phase/quadrature Modulator (10) einlangenden optischen Signal ($S_o$) an einen weiteren nested Mach-Zehnder-Modulator (2) des polarization-multiplexed inphase/quadrature Modulators (10) weitergeleitet wird,
- **dass** zumindest ein Anteil ($S_{o,M2}$) des vom weiteren nested Mach-Zehnder-Modulator (2) bereitgestellten optischen Ausgangssignals an eine weitere Monitorphotodiode (6) weitergeleitet wird, und
- **dass** ein Zufallssignal in Form des am elektrischen Monitorphotodiodenausgang (62) der weiteren Monitorphotodiode (6) anliegenden elektrischen Signals ($S_{el,D2}$) bereitgestellt wird,

wobei insbesondere vorgesehen ist, dass die Arbeitspunkte der nested Mach-Zehnder-Modulatoren (1, 2) derart vorgegeben werden, dass der Gleichanteil der Photodiodenströme der beiden Monitorphotodioden (5, 6) gleich ist, wobei vorzugsweise die an den elektrischen Monitorphotodiodenausgängen (52, 62) der Monitorphotodiode (5, 6) anliegenden elektrischen Signale ($S_{el,D1}$, $S_{el,D2}$) verknüpft werden, sodass derart ein verstärktes, analoges Zufallssignal ($S_{va}$) bereitgestellt wird, wobei insbesondere vorgesehen ist, dass die Differenz der elektrischen Signale ($S_{el,D1}$, $S_{el,D2}$) gebildet wird, wobei das verstärkte, analoge Zufallssignal ($S_{va}$), gegebenenfalls gefiltert und, in ein binäres Zufallssignal ($S_b$) umgewandelt wird.

10. Verfahren nach Anspruch 9, **dadurch gekennzeichnet, dass** die Entropie des binären Zufallssignals ($S_b$) ermittelt wird und dass daraus ein binäres Zufallssignal ($S_{EE}$) mit verbesserten statistischen Eigenschaften, insbesondere erhöhter Entropie pro bit, vorzugsweise eine Zufallszahl mit erhöhter Entropie, gegebenenfalls unter Einbeziehung einer vorgegebenen Entropiezahl ($\varepsilon$), berechnet wird,

wobei insbesondere das binäre Zufallssignal ($S_{EE}$) mit verbesserten statistischen Eigenschaften, insbesondere erhöhter Entropie pro bit, gegebenenfalls unter Einbeziehung einer vorgegebenen Zufallszahl, nach einem Zufallszahlenextraktionsverfahren, insbesondere mittels von Neumann-Extraktion oder Universal Hashing oder Toeplitz Hashing, berechnet wird.

11. Verfahren nach einem der Ansprüche 8 bis 10, **dadurch gekennzeichnet, dass** die beiden Betriebszustände gleichzeitig genutzt werden, wobei der Frequenzbereich des polarization-multiplexed in-phase/quadrature Modulators (10) derart aufgeteilt wird, sodass der Frequenzbereich des Datensignals und der Frequenzbereich des zumindest einen Zufallssignals, insbesondere der Zufallszahlen, einander nicht überlappen, sodass ein Übersprechen zwischen den beiden Signalen unterdrückt wird.

**Claims**

1. An arrangement (100) for generating a random signal, comprising

- an optical source (4), in particular a laser,
- a polarisation-multiplexed in-phase/quadrature modulator (10) comprising the following components:

    o an optical modulator input (101) to which the optical source (4) is connected,
    o at least one nested Mach-Zehnder modulator (1), wherein the at least one nested Mach-Zehnder modulator (1) is connected downstream of the optical modulator input (101) and
    wherein the at least one nested Mach-Zehnder modulator (1) has an optical output (15) and at least one electrical input (16) for specifying the real part and/or the imaginary part of an optical signal,

- a control unit (3) connected to the electrical input (16) of the nested Mach-Zehnder modulator (1), wherein the control unit (3) is configured to specify at least one operating point of the polarisation-multiplexed in-phase/quadrature modulator (100),
- wherein at least one monitor photodiode (5) is connected downstream of the polarisation-multiplexed in-phase/quadrature modulator (10), wherein the monitor photodiode (5) is connected downstream of the optical output (15) of the nested Mach-Zehnder modulator (1) and has an electrical monitor photodiode output (52), so that an optical signal provided by the nested Mach-Zehnder modulator (1) can be converted into an electrical signal, and
- wherein the monitor photodiode output (52) of the monitor photodiode (5) forms a random output (12) of the arrangement (100) for providing a generated random signal, **characterised in that**
- that the polarisation-multiplexed in-phase/quadrature modulator (10) has two operating states,

  - wherein the polarisation-multiplexed in-phase/quadrature modulator (10) is configured, in the first operating state, to transmit a data signal via the optical output (102) of the polarisation-multiplexed in-phase/quadrature modulator (10) and
  - in the second operating state, to generate the random signal, and

- that the polarisation-multiplexed in-phase/quadrature modulator (10) is configured to switch between the two operating states by changing its operating point.

2. An arrangement (100) according to claim 1, **characterised in that**

   - that the polarisation-multiplexed in-phase/quadrature modulator (10) comprises an input beam splitter (17), wherein the optical modulator input (101) is connected to the input (171) of the input beam splitter (17), and wherein a first output (172) of the input beam splitter (40) is connected to the optical input (14) of the nested Mach-Zehnder modulator (1), and
   - that the arrangement comprises a further nested Mach-Zehnder modulator (2), wherein a second output (173) of the input beam splitter (40) is connected to the optical input (21) of the further nested Mach-Zehnder modulator (2) and wherein the further nested Mach-Zehnder modulator (2) has an optical output (22) and at least one electrical input (23) for specifying the real part and/or the imaginary part of an optical signal,
that the control unit (3), or optionally a further control unit, is connected to the electrical input (23) of the further nested Mach-Zehnder modulator (2),
that at least one further monitor photodiode (6) is connected downstream of the polarisation-multiplexed in-phase/quadrature modulator (10), wherein the further monitor photodiode (6) is connected downstream of the optical output (22) of the further nested Mach-Zehnder modulator (2) and has an electrical monitor photodiode output (62), so that an optical signal provided by the further nested Mach-Zehnder modulator (2) can be converted into an electrical signal, and
that the monitor photodiode output (62) of the further monitor photodiode (6) forms a random output (12') of the arrangement (100) for providing a generated random signal, in particular generated random numbers,
wherein, if applicable, the control unit (3), and/or, where applicable, the further control unit, is designed to set the operating points of the nested Mach-Zehnder modulator (1) and the further nested Mach-Zehnder modulator (2) such that the DC component of the photodiode current of the monitor photodiode (5) and the further monitor photodiode (6) is equal.

3. An arrangement (100) according to one of the preceding claims, **characterised in that**

   - that the arrangement (100) comprises an internal beam splitter (18), wherein a first optical output (182) of the internal beam splitter (18) is connected to the optical monitor photodiode input (51) of the monitor photodiode (5) and/or
   - that the assembly (100) comprises a further internal beam splitter (19), wherein a first optical output (192) of the further internal beam splitter (19) is connected to the optical monitor photodiode input (61) of the further monitor photodiode (6).

4. An arrangement according to one of claims 2 or 3, **characterised in that** the electrical monitor photodiode output (52) of the monitor photodiode (5) and the electrical monitor photodiode output (62) of the further monitor photodiode (6) are connected to a conversion unit (7), wherein the output of the conversion unit (7) forms the random output (12) of the arrangement (100),

   - that the conversion unit (7) comprises, in particular, a transimpedance amplifier (8),

     wherein the transimpedance amplifier (8) has a first electrical transimpedance amplifier input (81), a second electrical transimpedance amplifier input (82) and an electrical transimpedance amplifier output (83), wherein the electrical monitor photodiode output (52) of the monitor photodiode (5) is connected to the first electrical transimpedance amplifier input (81) and wherein the electrical monitor photodiode output (62) of the further monitor photodiode (6) is connected to the second electrical transimpedance amplifier input (82),

- **in that** the transimpedance amplifier (8) is specifically designed to form and amplify a function of the electrical signals present at the electrical monitor photodiode outputs (52, 62) of the monitor photodiodes (5, 6), in particular of the currents flowing through the electrical monitor photodiode outputs (52, 62) of the monitor photodiodes (5, 6), and to provide an amplified, analogue random signal at the transimpedance amplifier output (83), wherein it is preferably provided that the transimpedance amplifier output (83) forms the output of the conversion unit (7), and
- that the transimpedance amplifier (8) is specifically designed to form the difference between the electrical signals present at the electrical monitor photodiode outputs (52, 62) of the monitor photodiodes (5, 6), in particular the currents flowing through the electrical monitor photodiode outputs (52, 62) of the monitor photodiodes (5, 6).

5. An arrangement according to claim 4, **characterised in that** the conversion unit (7) comprises an analogue signal processing unit (70), wherein the analogue signal processing unit (70) has an electrical input (71) and an electrical output (72) and

wherein the electrical transimpedance amplifier output (83) is connected to the electrical input (71) of the analogue signal processing unit (70), wherein the analogue signal processing unit (70) is configured to filter the amplified analogue random signal provided at the transimpedance amplifier output (83) and to provide it at the electrical output (72) of the analogue signal processing unit (70), wherein it is in particular provided that the electrical output (72) of the analogue signal processing unit (70) forms the output of the conversion unit (7), whereby it is preferably provided that

a) the conversion unit (7) comprises an analogue-to-digital converter (9), wherein the analogue-to-digital converter (9) has an electrical converter input (91) and an electrical converter output (92), and
b) wherein the electrical transimpedance amplifier output (83) is connected to the electrical converter input (91) of the analogue-to-digital converter (9), in particular to the electrical output (72) of the analogue signal processing unit (70),
c) wherein the analogue-to-digital converter (9) is configured to generate a binary random signal on the basis of the amplified analogue random signal provided at the transimpedance amplifier output (83), in particular at the electrical output (72) of the analogue signal processing unit (70), and to provide it at the electrical converter output (92), and
d) wherein it is in particular provided that the electrical converter output (92) forms the output of the conversion unit (7).

6. An arrangement according to one of claims 4 or 5, **characterised in that** the conversion unit (7) comprises a digital signal processing unit (11), wherein the digital signal processing unit (11) has an electrical signal input (111) and an electrical signal output (112) and

wherein the electrical converter output (92) is connected to the electrical signal input (111) of the digital signal processing unit (11), and
wherein the digital signal processing unit (11) is configured to generate, from the binary random signal provided at the electrical converter output (92), a binary random signal, in particular a random number, with improved statistical properties compared to the entropy of the binary random signal provided by the analogue-to-digital converter (9), and to make it available at its electrical signal output (112),
wherein it is in particular provided that the electrical signal output (112) of the digital signal processing unit (11) forms the output of the conversion unit (7),
whereby it is specifically provided

a) that the conversion unit (7) comprises an entropy estimator (13), wherein the entropy estimator (13) is configured to derive, from the known behaviour of the optical components of the arrangement (100), in particular the optical source (4) and/or the polarisation-multiplexed in-phase/quadrature modulator (10), and the electrical components of the arrangement (100), in particular the control unit (3) and/or the transimpedance amplifier (8) and/or the analogue-to-digital converter (9), to calculate and maintain an entropy, in particular the Shannon entropy or the minimum entropy, or a conditional entropy, in particular the conditional Shannon entropy or the conditional minimum entropy, of the binary random signal provided at the electrical converter output (92), or

b) that the conversion unit (7) comprises an entropy estimator (13), wherein the entropy estimator (13) is configured to calculate, from the known behaviour of the optical components of the arrangement (200), in particular the optical source (4) and/or the polarisation-multiplexed in-phase/quadrature modulator (10), and the electrical components of the arrangement (200), in particular the control unit (3) and/or the transimpedance amplifier (8) and/or the analogue-to-digital converter (9), as well as on the basis of predetermined parameters, in particular on the basis of a predetermined lower bound for an entropy, a parameterised entropy, in particular the epsilon-smooth minimum entropy, or a parameterised conditional entropy, in particular the conditional epsilon-smooth minimum entropy, of the binary random signal provided at the electrical converter output (92) and to keep it available, wherein it is preferably provided that the digital signal processing unit (11) is configured to utilise the entropy determined by the entropy estimator (13) to generate a random number with a defined entropy per bit, in particular with an entropy as close as possible to 1 bit per bit, according to a random number extraction method, in particular by means of von Neumann extraction, and to make it available at its electrical signal output (112).

7. An arrangement according to claim 6, **characterised in that** the digital signal processing unit (11) is configured to utilise the entropy determined by the entropy estimator (13) as well as a predetermined random number, in particular one stored in the digital signal processing unit (11), in order to generate a random number with a defined entropy per bit, in particular with an entropy as close as possible to 1 bit per bit or with a distribution that is epsilon-close to a uniform distribution, in accordance with a random number extraction method, in particular by means of universal hashing and/or Toeplitz hashing, and to make it available at its electrical signal output (112).

8. Method for generating a random signal using an arrangement (200), in particular according to one of claims 1 to 7, comprising an optical source (4) and a polarisation-multiplexed in-phase/quadrature modulator (10),

- wherein an optical signal ($S_o$) from the optical source (4), in particular a laser, is fed to the optical input (101) of the polarisation-multiplexed in-phase/quadrature modulator (10),
- wherein at least a portion ($S'_o$) of the optical signal ($S_o$) arriving at the optical input (101) of the polarisation-multiplexed in-phase/quadrature modulator (10) is forwarded to a nested Mach-Zehnder modulator (1) of the polarisation-multiplexed in-phase/quadrature modulator (10),
- wherein at least a portion ($S_{o,M1}$) of the optical output signal provided by the nested Mach-Zehnder modulator (1) is forwarded to a monitor photodiode (5), and
- wherein a random signal is provided in the form of the electrical signal ($S_{el,D1}$) present at the electrical monitor photodiode output (52) of the monitor photodiode (5),

**characterised in that,**

that the polarisation-multiplexed in-phase/quadrature modulator (10) has two operating states,

- wherein, in the first operating state, a data signal is transmitted via the optical output (102) of the polarisation-multiplexed in-phase/quadrature modulator (10) and
- wherein, in the second operating state, the random signal is generated, and

that switching between the two operating states is effected by changing the operating point of the polarisation-multiplexed in-phase/quadrature modulator (10).

9. A method according to claim 8, **characterised in that**

- that a further component ($S''_o$) of the optical signal ($S_o$) arriving at the optical input (101) of the polarisation-multiplexed in-phase/quadrature modulator (10) is forwarded to a further nested Mach-Zehnder modulator (2) of the polarisation-multiplexed in-phase/quadrature modulator (10),
- that at least one component ($S_{o,M2}$) of the optical output signal provided by the further nested Mach-Zehnder modulator (2) is forwarded to a further monitor photodiode (6), and
- that a random signal is provided in the form of the electrical signal ($S_{el,D2}$) present at the electrical monitor photodiode output (62) of the further monitor photodiode (6),

whereby it is in particular provided that the operating points of the nested Mach-Zehnder modulators (1, 2) are set such that the DC component of the photodiode currents of the two monitor photodiodes (5, 6) is equal, whereby the electrical signals (S(el,D1), S(el,D2)) present at the electrical monitor photodiode outputs (52, 62) of the monitor photodiodes (5, 6) are combined, so that an amplified, analogue random signal ($S_{va}$) is provided, wherein it is in particular provided that the difference between the electrical signals ($S_{el,D1}$,$S_{el,D2}$) is formed, wherein the amplified analogue random signal ($S_{va}$) is, if necessary, filtered and converted into a binary random signal ($S_b$).

10. Method according to claim 9, **characterised in that** the entropy of the binary random signal ($S_b$) is determined and that a binary random signal ($S_{EE}$) with improved statistical properties, in particular increased entropy per bit, preferably a random number with increased entropy, is calculated from it, optionally incorporating a predetermined entropy value ($\varepsilon$), wherein, in particular, the binary random signal ($S_{EE}$) with improved statistical properties, in particular increased entropy per bit, is calculated, optionally incorporating a predetermined random number, according to a random number extraction method, in particular by means of von Neumann extraction or universal hashing or Toeplitz hashing.

11. A method according to any one of claims 8 to 10, **characterised in that** the two operating states are used simultaneously, wherein the frequency range of the polarisation-multiplexed in-phase/quadrature modulator (10) is divided in such a way that the frequency range of the data signal and the frequency range of the at least one random signal, in particular the random numbers, do not overlap, thereby suppressing crosstalk between the two signals.

**Revendications**

1. Dispositif (100) pour générer un signal aléatoire, comprenant

- une source optique (4), en particulier un laser,
- un modulateur en phase/quadrature à multiplexage de polarisation (10), qui comprend les éléments suivants :

o une entrée de modulateur optique (101) à laquelle est raccordée la source optique (4),
o au moins un modulateur de Mach-Zehnder emboîté (1), ledit au moins un modulateur de Mach-Zehnder emboîté (1) étant monté en aval de l'entrée optique du modulateur (101) et

dans lequel ledit au moins un modulateur Mach-Zehnder emboîté (1) comporte une sortie optique (15) et au moins une entrée électrique (16) pour prédéfinir la partie réelle et/ou la partie imaginaire d'un signal optique,

- une unité de commande (3) qui est raccordée à l'entrée électrique (16) du modulateur Mach-Zehnder imbriqué (1), l'unité de commande (3) étant conçue pour définir au moins un point de fonctionnement du modulateur à multiplexage de polarisation en phase/quadrature (100),
- au moins une photodiode de surveillance (5) étant disposée en aval du modulateur à multiplexage de polarisation en phase/quadrature (10), ladite photodiode de surveillance (5) étant placée en aval de la sortie optique (15) du modulateur de Mach-Zehnder emboîté (1) et comportant une sortie électrique de photodiode de surveillance (52), de sorte qu'un signal optique fourni par le modulateur de Mach-Zehnder emboîté (1) peut être converti en un signal électrique, et
- la sortie de photodiode de surveillance (52) de la photodiode de surveillance (5) formant une sortie aléatoire (12) du dispositif (100) pour fournir un signal aléatoire généré, **caractérisé en ce que**
- le modulateur en phase/quadrature à multiplexage de polarisation (10) présente deux états de fonctionnement,

- le modulateur en phase/quadrature à multiplexage de polarisation (10) étant conçu pour, dans le premier état de fonctionnement, transmettre un signal de données via la sortie optique (102) du modulateur en phase/quadrature à multiplexage de polarisation (10) et
- de générer le signal aléatoire dans le deuxième état de fonctionnement, et

- **en ce que** le modulateur en phase/quadrature à multiplexage de polarisation (10) est conçu pour passer d'un état de fonctionnement à l'autre en modifiant son point de fonctionnement.

2. Dispositif (100) selon la revendication 1, **caractérisé en ce que**

- **en ce que** le modulateur en phase/quadrature à multiplexage par polarisation (10) comporte un séparateur de faisceau d'entrée (17), l'entrée optique du modulateur (101) étant reliée à l'entrée (171) du séparateur de faisceau d'entrée (17), et une première sortie (172) du séparateur de faisceau d'entrée (40) étant reliée à l'entrée optique (14) du modulateur Mach-Zehnder emboîté (1) et

- que le dispositif comprend un autre modulateur de Mach-Zehnder emboîté (2), une deuxième sortie (173) du séparateur de faisceau d'entrée (40) étant reliée à l'entrée optique (21) de l'autre modulateur de Mach-Zehnder emboîté (2) et l'autre modulateur de Mach-Zehnder emboîté (2) comporte une sortie optique (22) et au moins une entrée électrique (23) pour la spécification de la partie réelle et/ou de la partie imaginaire d'un signal optique, que l'unité de commande (3), le cas échéant une autre unité de commande, est raccordée à l'entrée électrique (23) de l'autre modulateur Mach-Zehnder imbriqué (2),

qu'au moins une autre photodiode de contrôle (6) est montée en aval du modulateur à multiplexage de polarisation en phase/quadrature (10), ladite autre photodiode de contrôle (6) est montée en aval de la sortie optique (22) de l'autre modulateur Mach-Zehnder imbriqué (2) et comporte une sortie électrique de photodiode de surveillance (62), de sorte qu'un signal optique fourni par l'autre modulateur Mach-Zehnder imbriqué (2) peut être converti en un signal électrique, et

que la sortie de photodiode de surveillance (62) de la photodiode de surveillance supplémentaire (6) forme une sortie aléatoire (12') du dispositif (100) pour fournir un signal aléatoire généré, en particulier des nombres aléatoires générés,

l'unité de commande (3), et/ou, le cas échéant, l'autre unité de commande, est conçue pour prédéfinir les points de fonctionnement du modulateur Mach-Zehnder imbriqué (1) et de l'autre modulateur Mach-Zehnder imbriqué (2) de telle sorte que la composante continue du courant de photodiode de la photodiode de contrôle (5) et de l'autre photodiode de contrôle (6) soit identique.

3. Dispositif (100) selon l'une des revendications précédentes, caractérisé en ce

- en ce que le dispositif (100) comprend un séparateur de faisceau interne (18), une première sortie optique (182) du séparateur de faisceau interne (18) étant raccordée à l'entrée optique (51) de la photodiode de contrôle (5) et/ou
- en ce que le dispositif (100) comprend un autre séparateur de faisceau interne (19), une première sortie optique (192) de cet autre séparateur de faisceau interne (19) étant reliée à l'entrée optique (61) de l'autre photodiode de surveillance (6).

4. Dispositif selon l'une des revendications 2 ou 3, **caractérisé en ce que** la sortie électrique (52) de la photodiode de surveillance (5) et la sortie électrique de la photodiode de surveillance (62) de l'autre photodiode de surveillance (6) sont connectées à une unité de conversion (7), la sortie de l'unité de conversion (7) formant la sortie aléatoire (12) du dispositif (100),

> - **en ce que** l'unité de conversion (7) comprend notamment un amplificateur à transimpédance (8),

> > l'amplificateur à transimpédance (8) comportant une première entrée électrique d'amplificateur à transimpédance (81), une deuxième entrée électrique d'amplificateur à transimpédance (82) et une sortie électrique d'amplificateur à transimpédance (83),
> > la sortie électrique de la photodiode de surveillance (52) de la photodiode de surveillance (5) est connectée à la première entrée électrique de l'amplificateur à transimpédance (81) et la sortie électrique de la photodiode de surveillance (62) de l'autre photodiode de surveillance (6) est connectée à la deuxième entrée électrique de l'amplificateur à transimpédance (82),

> - **en ce que** l'amplificateur à transimpédance (8) est notamment conçu pour former et amplifier une fonction des signaux électriques présents aux sorties électriques des photodiodes de surveillance (52, 62) des photodiodes de surveillance (5, 6), en particulier des courants circulant à travers les sorties électriques des photodiodes de surveillance (52, 62) des photodiodes de surveillance (5, 6), et de fournir ainsi un signal aléatoire analogique amplifié à la sortie de l'amplificateur à transimpédance (83), étant prévu de préférence que la sortie de l'amplificateur à transimpédance (83) constitue la sortie de l'unité de conversion (7), et
> - que l'amplificateur à transimpédance (8) est notamment conçu pour former la différence entre les signaux électriques présents aux sorties électriques (52, 62) des photodiodes de surveillance (5, 6), en particulier entre les courants circulant à travers les sorties électriques (52, 62) des photodiodes de surveillance (5, 6).

5. Dispositif selon la revendication 4, **caractérisé en ce que** l'unité de conversion (7) comprend une unité de traitement de signaux analogiques (70), l'unité de traitement de signaux analogiques (70) présentant une entrée électrique (71) et une sortie électrique (72) et

la sortie électrique de l'amplificateur à transimpédance (83) est connectée à l'entrée électrique (71) de l'unité de traitement de signaux analogiques (70),

l'unité de traitement de signaux analogiques (70) étant conçue pour filtrer le signal aléatoire analogique amplifié fourni à la sortie de l'amplificateur à transimpédance (83) et pour fournir, à la sortie électrique (72) de l'unité de traitement de signaux analogiques (70), étant notamment prévu que la sortie électrique (72) de l'unité de traitement de signaux analogiques (70) constitue la sortie de l'unité de conversion (7), il est de préférence prévu que

a) l'unité de conversion (7) comprenne un convertisseur analogique-numérique (9), le convertisseur analogique-numérique (9) présentant une entrée électrique de convertisseur (91) et une sortie électrique de convertisseur (92) et

b) la sortie électrique de l'amplificateur à transimpédance (83) est connectée à l'entrée électrique (91) du convertisseur analogique-numérique (9), en particulier à la sortie électrique (72) de l'unité de traitement de signaux analogiques (70),

c) le convertisseur analogique-numérique (9) étant conçu pour générer, sur la base du signal aléatoire analogique amplifié fourni à la sortie de l'amplificateur à transimpédance (83), en particulier à la sortie électrique (72) de l'unité de traitement de signaux analogiques (70), et de le fournir à la sortie électrique du convertisseur (92), et

d) dans lequel il est notamment prévu que la sortie électrique du convertisseur (92) constitue la sortie de l'unité de conversion (7).

6. Dispositif selon l'une des revendications 4 ou 5, **caractérisé en ce que** l'unité de conversion (7) comprend une unité de traitement de signaux numériques (11), l'unité de traitement de signaux numériques (11) présentant une entrée de signal électrique (111) et une sortie de signal électrique (112) et

la sortie électrique du convertisseur (92) est connectée à l'entrée de signal électrique (111) de l'unité de traitement de signal numérique (11), et

l'unité de traitement de signal numérique (11) étant conçue pour générer, à partir du signal aléatoire binaire fourni à la sortie du convertisseur électrique (92), un signal aléatoire binaire, en particulier un nombre aléatoire, présentant des propriétés statistiques améliorées par rapport à l'entropie du signal aléatoire binaire fourni par le convertisseur analogique-numérique (9) et de le fournir à sa sortie de signal électrique (112),

il est notamment prévu que la sortie de signal électrique (112) de l'unité de traitement de signal numérique (11) constitue la sortie de l'unité de conversion (7),

il est notamment prévu

a) que l'unité de conversion (7) comprenne un estimateur d'entropie (13), l'estimateur d'entropie (13) étant conçu pour, à partir du comportement connu des composants optiques du dispositif (100), en particulier de la source optique (4) et/ou du modulateur à multiplexage de polarisation en phase/quadrature (10), et des composants électriques du dispositif (100), en particulier de l'unité de commande (3) et/ou de l'amplificateur à transimpédance (8) et/ou du convertisseur analogique-numérique (9), de calculer et de maintenir à disposition une entropie, en particulier l'entropie de Shannon ou l'entropie minimale, ou une entropie conditionnelle, en particulier l'entropie conditionnelle de Shannon ou l'entropie conditionnelle minimale, du signal aléatoire binaire fourni à la sortie électrique du convertisseur (92), ou

b) que l'unité de conversion (7) comprend un estimateur d'entropie (13), l'estimateur d'entropie (13) étant conçu pour calculer, à partir du comportement connu des composants optiques du dispositif (200), en particulier de la source optique (4) et/ou du modulateur à multiplexage de polarisation en phase/quadrature (10), et des composants électriques du dispositif (200), en particulier de l'unité de commande (3) et/ou de l'amplificateur à transimpédance (8) et/ou du convertisseur analogique-numérique (9), ainsi qu'à l'aide de paramètres prédéfinis, en particulier à l'aide d'une borne inférieure prédéfinie pour une entropie, une entropie paramétrée, en particulier l'entropie minimale epsilon-smooth, ou une entropie conditionnelle paramétrée, en particulier l'entropie conditionnelle epsilon-smooth, du signal aléatoire binaire fourni à la sortie électrique du convertisseur (92) et de le maintenir à disposition, étant prévu de préférence que l'unité de traitement de signal numérique (11) soit conçue pour utiliser l'entropie déterminée par l'estimateur d'entropie (13) pour générer un nombre aléatoire présentant une entropie définie par bit, en particulier une entropie aussi proche que possible de 1 bit par bit, selon un procédé d'extraction de nombres aléatoires, en particulier au moyen de l'extraction de Neumann, et de le fournir à sa sortie de signal électrique (112).

7. Dispositif selon la revendication 6, **caractérisé en ce que** l'unité de traitement de signaux numériques (11) est conçue pour utiliser l'entropie déterminée par l'estimateur d'entropie (13) ainsi qu'un nombre aléatoire prédéfini, notamment stocké dans l'unité de traitement de signaux numériques (11), afin de générer un nombre aléatoire présentant une entropie définie par bit, en particulier avec une entropie aussi proche que possible de 1 bit par bit ou avec une distribution proche de l'uniformité, selon un procédé d'extraction de nombres aléatoires, en particulier au moyen d'un hachage universel et/ou d'un hachage de Toeplitz, et de le fournir à sa sortie de signal électrique (112).

8. Procédé de génération d'un signal aléatoire à l'aide d'un dispositif (200), en particulier selon l'une des revendications 1 à 7, comprenant une source optique (4) et un modulateur en phase/quadrature à multiplexage de polarisation (10),

   - dans lequel un signal optique ($S_o$) provenant de la source optique (4), en particulier d'un laser, est acheminé vers l'entrée optique (101) du modulateur en phase/quadrature à multiplexage de polarisation (10),
   - au moins une partie ($S'_o$) du signal optique ($S_o$) arrivant à l'entrée optique (101) du modulateur en phase/quadrature à multiplexage par polarisation (10) est transmise à un modulateur de Mach-Zehnder emboîté (1) du modulateur en phase/quadrature à multiplexage par polarisation (10),
   - au moins une partie ($S_{o,M1}$) du signal optique de sortie fourni par le modulateur Mach-Zehnder imbriqué (1) étant transmise à une photodiode de surveillance (5), et
   - un signal aléatoire étant fourni sous la forme du signal électrique ($S_{el,D1}$) présent à la sortie électrique (52) de la photodiode de surveillance (5),

   **caractérisé en ce que,**

   que le modulateur en phase/quadrature à multiplexage par polarisation (10) présente deux états de fonctionnement,

   - dans le premier état de fonctionnement, un signal de données étant transmis via la sortie optique (102) du modulateur en phase/quadrature à multiplexage par polarisation (10) et
   - dans le deuxième état de fonctionnement, le signal aléatoire est généré, et

que le passage d'un état de fonctionnement à l'autre s'effectue en modifiant le point de fonctionnement du modulateur en phase/quadrature à multiplexage par polarisation (10).

9. Procédé selon la revendication 8, **caractérisé en ce que**

   - **en ce qu'**une autre composante ($S''_o$) du signal optique ($S_o$) arrivant à l'entrée optique (101) du modulateur en phase/quadrature à multiplexage par polarisation (10) est transmise à un autre modulateur de Mach-Zehnder imbriqué (2) du modulateur en phase/quadrature à multiplexage par polarisation (10),
   - qu'au moins une partie ($S_{o,M2}$) du signal optique de sortie fourni par l'autre modulateur Mach-Zehnder imbriqué (2) est transmise à une autre photodiode de surveillance (6), et
   - qu'un signal aléatoire est fourni sous la forme du signal électrique ($S_{el,D2}$) présent à la sortie électrique (62) de la photodiode de surveillance supplémentaire (6),

   où il est notamment prévu que les points de fonctionnement des modulateurs Mach-Zehnder imbriqués (1, 2) soient prédéfinis de telle sorte que la composante continue des courants de photodiode des deux photodiodes de surveillance (5, 6) soit identique, les signaux électriques (S(el,D1), S(el,D2)) présents aux sorties électriques des photodiodes de surveillance (52, 62) des photodiodes de contrôle (5, 6) soient combinés, de sorte qu'un signal aléatoire analogique amplifié ($S_{va}$) soit ainsi fourni, étant notamment prévu que la différence des signaux électriques ($S_{el,D1}$, $S_{el,D2}$) soit formée, le signal aléatoire analogique amplifié ($S_{va}$) étant, le cas échéant, filtré et converti en un signal aléatoire binaire ($S_b$).

10. Procédé selon la revendication 9, **caractérisé en ce que** l'entropie du signal aléatoire binaire ($S_b$) est déterminée et **en ce qu'**il en résulte un signal aléatoire binaire ($S_{EE}$) présentant des propriétés statistiques améliorées, en particulier une entropie par bit accrue, de préférence un nombre aléatoire à entropie accrue, est calculé à partir de celui-ci, le cas échéant en tenant compte d'une valeur d'entropie prédéfinie ($\varepsilon$), le signal aléatoire binaire ($S_{EE}$) présentant des propriétés statistiques améliorées, notamment une entropie par bit accrue, étant en particulier calculé, le cas échéant en tenant compte d'un nombre aléatoire prédéfini, selon un procédé d'extraction de nombres aléatoires, notamment au moyen de l'extraction de Neumann, du hachage universel ou du hachage de Toeplitz.

11. Procédé selon l'une des revendications 8 à 10, **caractérisé en ce que** les deux états de fonctionnement sont utilisés simultanément, la gamme de fréquences du modulateur en phase multiplexé par polarisation quadrature (10) est divisée de telle sorte que la gamme de fréquences du signal de données et celle d'au moins un signal aléatoire, en particulier des nombres aléatoires, ne se chevauchent pas, ce qui permet de supprimer la diaphonie entre les deux signaux.

Fig. 1

Fig. 2

EP 4 168 889 B1

Fig. 3

EP 4 168 889 B1

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2015331672 A
- US 2011170161 A1

**In der Beschreibung aufgeführte Nicht-Patentliteratur**

- **MIGUEL HERRERO-COLLANTES** ; **JUAN CARLOS GARCIA-ESCARTIN**. Quantum Random Number Generators. *Reviews of Modern Physics*, 2017, vol. 89, 015004
- **TOMAMICHEL, MARCO**. Quantum Information Processing with Finite Resources. Springer
- **TOMAMICHEL, MARCO**. Quantum Information Processing with Finite Resources. Springer, Mathematical Foundations
- **JOHN VON NEUMANN**. Various Techniques Used in Connection With Random Digits. *J. Res. Nat. Bur. Stand. Appl. Math. Series*, 1951, vol. 3, 36-38
- **CARTER, LARRY** ; **WEGMAN, MARK N.** Universal Classes of Hash Functions. *Journal of Computer and System Sciences.*, 1979, vol. 18 (2), 143-154
- **MANSOUR, Y.** ; **N. NISAN** ; **P. TIWARI**. The computational complexity of universal hashing. *Theoretical Computer Science*, 1993, vol. 107, 121-133